# EUROPEAN PATENT APPLICATION

(11) **EP 1 986 224 A1**
(43) Date of publication of application: **29.10.2008**
(21) Application number: 07714307.1
(22) Date of filing: 15.02.2007
(51) Int. Cl.: H01L 21/027, G03F 7/20

(54) **EXPOSURE APPARATUS, EXPOSING METHOD, AND DEVICE MANUFACTURING METHOD**

(30) Priority: 16.02.2006 JP 2006039926
(71) Applicant: Nikon Corporation, Tokyo 100-8331 (JP)
(72) Inventor: NAGASAKA, Hiroyuki, Tokyo 100-8331 (JP)
(74) Representative: Hooiveld, Arjen Jan Winfried
(86) International application number: PCT/JP2007/052777
(87) International publication number: WO 2007/094431

(57) **Abstract**

An exposure apparatus (EX) includes an optical system (PL) which irradiates a first exposure light (EL1) from a first pattern (PA1) onto a first exposure area (AR1) to form an image of the first pattern (PA1) on the first exposing are (AR1) and which irradiates second exposure light (EL2) from a second pattern (PA2) onto a second exposure area (AR2) to form an image of the second pattern (PA2) on the second exposing area (AR2); and a light receiving device (31) which receives a detecting light via at least a part of the optical system. The exposure apparatus further includes a detection system (30) which obtains, in parallel to at least a part of an operation of multiple-exposing a predetermined area on a substrate with the images of the first and second patterns, information about a positional relationship between the image of the first pattern and the substrate and information about a positional relationship between the image of the second pattern and the substrate via at least a part of the optical system (PL). The substrate can be efficiently well multi-exposed.

## Description

### TECHNICAL FIELD

The present invention relates to an exposure apparatus for exposing a substrate, an exposure method, and a method for producing a device.

### BACKGROUND ART

In relation to an exposure apparatus to be used in the photolithography step, an exposure apparatus, which multiple-exposes the substrate, is known as disclosed, for example, in Japanese Patent Application Laid-open No. 10-214783.

### DISCLOSURE OF THE INVENTION

### Task to Be Solved by the Invention:

In the multiple exposure, a plurality of masks are prepared to execute the exposure with each of the masks in some cases, and/or a plurality of illumination conditions are prepared to execute the exposure under different illumination conditions with the masks respectively. In such situations, it is necessary to take a time to exchange the mask, and/or it is necessary to take a time to change the illumination condition, etc. Therefore, there is such a possibility that the rate of operation of the exposure apparatus might be lowered, and the throughput might be deteriorated.

On the other hand, a microdevice (electronic device) such as a semiconductor device is formed by overlaying or superimposing a plurality of patterns on the substrate. In order to produce a desired device, it is important to perform the alignment for the patterns with each other efficiently and satisfactorily in the multiple exposure as well.

The present invention has been made taking the foregoing circumstances into consideration, an object of which is to provide an exposure apparatus, an exposure method, and a method for producing a device, wherein a substrate can be subjected to the multiple exposure efficiently. Another object of the present invention is to provide an exposure apparatus, an exposure method, and a method for producing a device, wherein patterns can be formed at any desired position on a substrate by the multiple exposure.

### Solution for the Task:

In order to achieve the objects as described above, the present invention adopts the following constructions corresponding to respective drawings as illustrated in embodiments. However, parenthesized reference numerals affixed to respective elements merely exemplify the elements by way of example, with which it is not intended to limit the respective elements.

According to a first aspect of the present invention, there is provided an exposure apparatus (EX) which exposes a substrate (P), comprising: an optical system (PL) which is capable of forming an image of a first pattern (PA1) in a first exposure area (AR1) by radiating a first exposure light (EL1) from the first pattern (PA1) onto the first exposure area (AR1) and which is capable of forming an image of a second pattern (PA2) different from the first pattern (PA1) in a second exposure area (AR2) by radiating a second exposure light (EL2) from the second pattern (PA2) onto the second exposure area (AR2); and a detecting system (30) which has a light-receiving device (31) receiving a detection light via at least a part of the optical system (PL) and which obtains information about a positional relationship between the image of the first pattern (PA1) and the substrate and information about a positional relationship between the image of the second pattern (PA2) and the substrate (P) via at least the part of the optical system (PL) concurrently with at least a part of an operation for multiple-exposing a predetermined area (S) on the substrate (P) with the image of the first pattern (PA1) formed in the first exposure area(AR1) and the image of the second pattern (PA2) formed in the second exposure area (AR2).

According to the first aspect of the present invention, it is possible to efficiently multiple-expose the substrate. Further, it is possible to obtain the information about the positional relationship among the image of the first pattern, the image of the second pattern, and the substrate concurrently with at least a part of the operation to perform the multiple exposure. It is possible to form the patterns at any desired position on the substrate based on the information obtained by using the detecting system.

According to a second aspect of the present invention, there is provided an exposure apparatus (EX) which exposes a substrate (P), comprising: an optical system (PL) including an optical element (20) into which a first exposure light (EL1) comes from a first pattern (PA1) and into which a second exposure light (EL2) comes from a second pattern (PA2) different from the first pattern (PA1), the optical system being capable of forming an image of the first pattern (PA1) and an image of the second pattern (PA2) in a first exposure area (AR1) and a second exposure area (AR2) respectively by irradiating at least a part of the first exposure light (EL1) from the optical element (20) and at least a part of the second exposure light (EL2) from the optical element (20) onto the first exposure area (AR1) and the second exposure area (AR2) respectively; and a detecting system (30) including a light-receiving device (31) which receives, as a detection light, a light traveling from the optical element (20) to an area (35a) different from the first exposure area (AR1) and the second exposure area (AR2); wherein a predetermined area (S) on the substrate (P) is multiple-exposed with the image of the first pattern (PA1) formed in the first exposure area (AR1) and the image of the second pattern (PA2) formed in the second exposure area (AR2).

According to the second aspect of the present invention, it is possible to efficiently multiple-expose the substrate. Further, it is possible to form, for example, the image of the first pattern and the image of the second pattern in the predetermined area on the substrate in the desired positional relationship based on the information obtained by using the detecting system.

According to a third aspect of the present invention, there is provided an exposure apparatus (EX) which exposes a substrate (P), comprising: a polarization splitting optical element (20) into which a first exposure light (EL1) comes from a first pattern (PA1) and a second exposure light (EL2) comes from a second pattern (PA2) different from the first pattern (PA1); and a detecting system (30) which detects a position of a first mark (RM1) associated with the first pattern (PA1) and a position of a second mark (RM2) associated with the second pattern (PA2) by detecting the first mark (RM1) and the second mark (RM2) via the polarization splitting optical element (20); wherein the first exposure light (EL1) and the second exposure light (EL2) from the polarization splitting optical element (20) are irradiated onto a first exposure area (AR1) and a second exposure area (AR2) respectively to form an image of the first pattern (PA1) and an image of the second pattern (PA2) in the first exposure area (AR1) and the second exposure area (AR2) respectively so that a predetermined area on the substrate (P) is multiple-exposed.

According to the exposure apparatus of the third aspect of the present invention, it is possible to efficiently multiple-expose the substrate while forming the image of the first pattern and the image of the second pattern in the predetermined area on the substrate in the desired positional relationship by using the polarization splitting optical element and the detecting system.

According to a fourth aspect of the present invention, there is provided a method for producing a device, the method comprising: exposing (SA9, 204) a substrate by using the exposure apparatus (EX) as defined in any one of the foregoing aspects; developing (204) the exposed substrate; and processing (205) the developed substrate.

According to the fourth aspect of the present invention, it is possible to produce the device by using the exposure apparatus which makes it possible to efficiently multiple-expose the substrate.

According to a fifth aspect of the present invention, there is provided an exposure method for exposing a substrate (P), the method comprising: multiple-exposing (SA9) a predetermined area on the substrate with an image of a first pattern (PA1) and an image of a second pattern (PA2) different from the first pattern (PA1) by radiating a first exposure light (EL1) onto the first exposure area (AR1) from the first pattern (PA1) via an optical system (PL) to form the image of the first pattern (PA1) in the first exposure area (AR1) while radiating a second exposure light (EL2) from the second pattern (PA2) onto a second exposure area (AR2) via the optical system (PL) to form the image of the second pattern (PA1) in the second exposure area (AR2); and obtaining (SA1 to SA4, SA9) information about a positional relationship between the image of the first pattern (PA1) and the substrate (P) and information about a positional relationship between the image of the second pattern (PA2) and the substrate (P) via at least a part of the optical system (PL) concurrently with at least a part of an operation of the multiple exposure.

According to the exposure method of the fifth aspect of the present invention, it is possible to obtain the information about the positional relationship among the image of the first pattern, the image of the second pattern, and the substrate concurrently with at least a part of the operation of the multiple exposure. Therefore, the patterns can be formed while being reliably overlaid at any desired position on the substrate.

According to a sixth aspect of the present invention, there is provided an exposure method for exposing a substrate (P), the method comprising: multiple-exposing (SA9) a predetermined area on the substrate with an image of a first pattern (PA1) and an image of a second pattern (PA2) different from the first pattern (PA1) by radiating a first exposure light (EL1) from the first pattern (PA1) onto a first exposure area (AR1) via an optical element (20) to form the image of the first pattern (PA1) in the first exposure area (AR1) while radiating a second exposure light (EL2) from the second pattern (PA2) onto a second exposure area (AR2) via the optical element (20) to form the image of the second pattern (PA2) in the second exposure area (AR2); and receiving (SA9), as a detection light, a light traveling from the optical element (20) to an area different from the first exposure area and the second exposure area.

According to the sixth aspect of the present invention, it is possible to efficiently multiple-expose the substrate. Further, it is possible to form, for example, the image of the first pattern and the image of the second pattern in the predetermined area on the substrate in the desired positional relationship based on the information obtained by receiving, as the detection light, the light (light beam) traveling from the optical element to the area that is different from the first exposure area and the second exposure area.

According to a seventh aspect of the present invention, there is provided an exposure method for exposing a substrate (P), the method comprising: making a first exposure light (EL1) from a first pattern (PA1) and a second exposure light (EL2) from a second pattern (PA2) different from the first pattern (PA1) to come into a polarization splitting optical element (20); detecting (SA1 to SA4, SA9) a position of a first mark (RM1) associated with the first pattern (PA1) and a position of a second mark (RM2) associated with the second pattern (PA2) by detecting the first mark (RM1) and the second mark (RM2) with a light via the polarization splitting optical element (20); and irradiating the first exposure light (EL1) and the second exposure light (EL2) from the polarization splitting optical element (20) onto a first exposure area (AR1) and a second exposure area (AR2) respectively to form an image of the first pattern (PA1) and an image of the second pattern (PA2) in the first exposure area (AR1) and the second exposure area (AR2) respectively so that a predetermined area on the substrate (P) is multiple-exposed (SA9).

According to the exposure method of the seventh aspect of the present invention, it is possible to efficiently multiple-expose the substrate while forming the image of the first pattern and the image of the second pattern in the predetermined area on the substrate in the desired positional relationship by the lights via the polarization splitting optical element.

According to an eighth aspect of the present invention, there is provided a method for producing a device, the method comprising: exposing (SA9, 204) a substrate by the exposure method as defined in any one of the foregoing aspects of the present invention; developing (204) the exposed substrate; and processing (205) the developed substrate. According to the method for producing the device of the eighth aspect of the present invention, it is possible to produce the device at a high throughput by using the exposure method which makes it possible to efficiently multiple-expose the substrate.

### Effect of the Invention:

According to the present invention, it is possible to efficiently multiple-expose the substrate. Further, it is possible to form the patterns at any desired position on the substrate by the multiple exposure. Therefore, it is possible to produce the device having the desired performance at the satisfactory productivity.

### BRIEF DESCRIPTION OF THE DRAWINGS

Fig. 1 shows a schematic construction view of an exposure apparatus according to a first embodiment.
Fig. 2(A) shows an example of a first mask held by a first mask stage, and Fig. 2(B) shows an example of a second mask held by a second mask stage.
Fig. 3 schematically shows a relationship between a shot area on a substrate and first and second exposure areas according to the first embodiment.
Fig. 4 shows a light-receiving device according to the first embodiment.
Fig. 5 shows a light-receiving surface of the light-receiving device according to the first embodiment.
Fig. 6 schematically shows images of first and second alignment marks formed on the light-receiving surface.
Fig. 7 schematically shows images of first and second alignment marks formed on the light-receiving surface.
Fig. 8 shows an example of a spatial image-measuring device.
Fig. 9 shows a flow chart illustrating an exposure method according to the first embodiment.
Fig. 10 shows a substrate stage as viewed from an upper position in order to explain an example of the exposure operation.
Fig. 11 schematically illustrates the exemplary exposure operation according to the first embodiment.
Figs. 12(A) and 12(B) schematically illustrate the exemplary exposure operation according to the first embodiment.
Fig. 13 shows a schematic construction of an exposure apparatus according to a second embodiment.
Fig. 14 schematically shows a relationship between a shot area on a substrate and first and second exposure areas according to the second embodiment.
Fig. 15 shows a light-receiving device according to the second embodiment.
Fig. 16 shows a light-receiving surface of the light-receiving device according to the second embodiment.
Fig. 17 shows a schematic construction of an exposure apparatus according to a third embodiment.
Fig. 18(A) shows an example of a first mask held by a first mask stage, and Fig. 18(B) shows an example of a second mask held by a second mask stage.
Fig. 19 shows alignment marks according to the third embodiment.
Fig. 20 shows a light-receiving device according to the third embodiment.
Fig. 21 shows a light-receiving surface of the light-receiving device according to the third embodiment.
Figs. 22(A) and 22(B) schematically illustrate an example of the exposure operation according to the third embodiment.
Fig. 23 shows a flow chart illustrating exemplary steps of producing a microdevice.

### Legend of reference numerals:

1: first mask stage, 2: second mask stage, 4: substrate stage, 5: controller, 6: storage device, 11: first optical system, 12: second optical system, 13: third optical system, 20: optical element, 21: first light-incident surface, 22: second light-incident surface, 23: first light-exit surface, 24: second light-exit surface, 30, 30': detecting system, 31: light-receiving device, 32: light-receiving surface, 40: radiating device, 41: first light-receiving device, 42: second light-receiving device, 43: light-receiving device, 45: first light-receiving surface, 46: second light-receiving surface, AR1: first exposure area, AR2: second exposure area, EL1: first exposure light, EL2: second exposure light, EX: exposure apparatus, IL1: first illumination system, IL2: second illumination system, La, Lb: detection light, M1: first mask, M2: second mask, P: substrate, PA1: first pattern, PA2: second pattern, PL: projection optical system, RM1, RM1': first alignment mark, RM2, RM2': second alignment mark, S: shot area.

### BEST MODE FOR CARRYING OUT THE INVENTION

Embodiments of the present invention will be explained below with reference to the drawings. However, the present invention is not limited to the embodiments. In the following description, a XYZ rectangular coordinates system is defined. The positional relationship concerning the respective members will be explained with reference to the XYZ rectangular coordinates system. An X axis direction is a predetermined direction in a horizontal plane, a Y axis direction is a direction which is perpendicular to the X axis direction in the horizontal plane, and a Z axis direction is a direction which is perpendicular to each of the X axis direction and the Y axis direction (i.e., vertical direction). The directions of rotation (inclination) about the X axis, the Y axis, and the Z axis are designated as θX, θY, and θZ directions respectively.

### First Embodiment

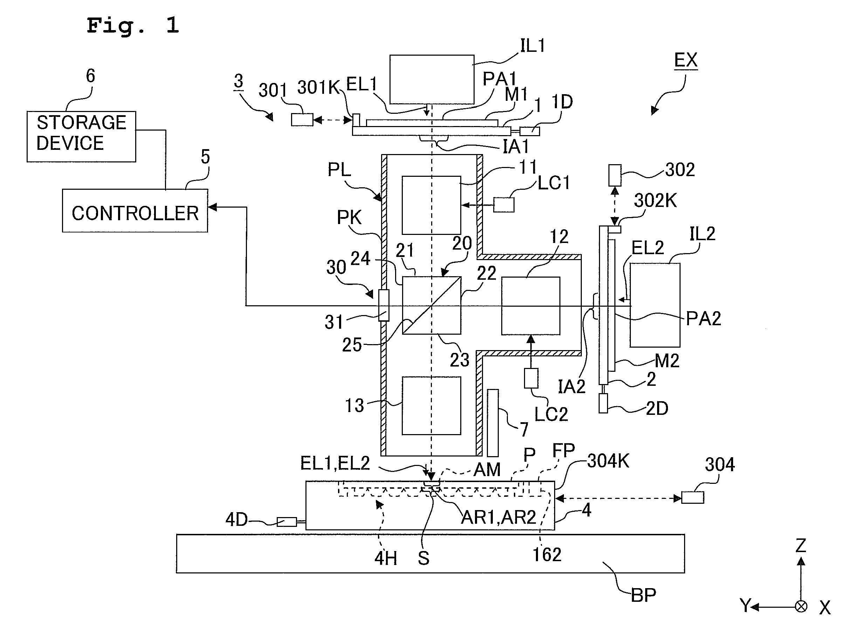

A first embodiment will be explained. Fig. 1 shows a schematic construction of an exposure apparatus EX according to the first embodiment. With reference to Fig. 1, the exposure apparatus EX includes the first mask stage 1 which is movable while holding a first mask M1 having a first pattern PA1, a second mask stage 2 which is movable while holding a second mask M2 having a second pattern PA2, a substrate stage 4 which is movable while holding a substrate P, a measuring system 3 which is capable of measuring the position information about the respective stages, a first illumination optical system IL1 which illuminates the first pattern PA1 of the first mask M1 with a first exposure light EL1, a second illumination system IL2 which illuminates the second pattern PA2 of the second mask M2 with a second exposure light EL2, a projection optical system PL which projects, onto the substrate P, an image of the first pattern PA1 illuminated with the first exposure light EL1 and an image of the second pattern PA2 illuminated with the second exposure light EL2, and a controller 5 which controls the operation of the entire exposure apparatus EX. The substrate stage 4 is movable on a base member BP on the light-exit side of the projection optical system PL, i.e., on the image plane side of the projection optical system PL. A storage device 6, which stores various types of information in relation to the exposure, is connected to the controller 5.

The substrate referred to herein includes, for example, those which have a base material including a semiconductor wafer such as a silicon wafer, etc. coated with a photosensitive material (photoresist). The substrate also includes those which are coated with various films including a protective film (top coat film), etc., distinctly from the photosensitive material. The mask includes a reticle which is formed with a device pattern to be subjected to the reduction projection onto the substrate. The mask has a predetermined pattern which is formed by using, for example, a light-shielding film such as chromium on a transparent plate member such as a glass plate. The transmission type mask is not limited to a binary mask having a pattern formed by a light-shielding film. The transmission type mask includes, for example, a phase shift mask of the spatial frequency modulation type or the half tone type. In this embodiment, the transmission type mask is used as the mask. However, it is also allowable to use a reflection type mask. In this embodiment, the first pattern PA1 and the second pattern PA2 are patterns which are different from each other. Further, the first and second masks M1, M2 are of the same type. However, the types of the first and second masks M1, M2 may be different from each other. For example, one of the first and second masks M1, M2 may be a binary mask, and the other of the first and second masks M1, M2 may be a phase shift reticle.

The projection optical system PL of this embodiment has an optical element 20 into which the first exposure light EL1 from the first pattern PA1 and the second exposure light EL2 from the second pattern PA2 are allowed to come. In this embodiment, a first exposure area AR1 and a second exposure area AR2 are defined in a predetermined positional relationship on the light-exit side of the projection optical system PL, i.e., on the image plane side of the projection optical system PL. In this embodiment, the first exposure area AR1 and the second exposure area AR2 are defined at a same position. The projection optical system PL of this embodiment has a first optical system 11 which guides the first exposure light EL1 from the first pattern PA1 to the optical element 20, a second optical system 12 which guides the second exposure light EL2 from the second pattern PA2 to the optical element 20, and a third optical system 13 which guides the first exposure light EL1 and the second exposure light EL2 from the optical element 20 to the first exposure area AR1 and the second exposure area AR2 respectively. The optical element 20 is capable of irradiating, via the third optical system 13, at least a part of the first exposure light EL1 coming via the first optical system 11 and at least a part of the second exposure light EL2 coming via the second optical system 12 onto the first exposure area AR1 and the second exposure area AR2 respectively. That is, the projection optical system PL of this embodiment is capable of radiating at least the part of the first exposure light EL1 and at least the part of the second exposure light EL2 from the optical element 20 onto the first exposure area AR1 and the second exposure area AR2 respectively.

The projection optical system PL is capable of forming the image of the first pattern PA1 in the first exposure area AR1 by radiating the first exposure light EL1 from the first pattern PA1 onto the first exposure area AR1. The projection optical system PL is capable of forming the image of the second pattern PA2 in the second exposure area AR2 by radiating the second exposure light EL2 from the second pattern PA2 onto the second exposure area AR2. That is, the exposure apparatus EX of this embodiment is capable of forming the image of the first pattern PA1 in the first exposure area AR1 with the first exposure light EL1 which is emitted from the first illumination system IL1 and which is radiated or irradiated onto the first exposure area AR1 via the first pattern PA1 and the projection optical system PL; and the exposure apparatus EX of this embodiment is capable of forming the image of the second pattern PA2 in the second exposure area AR2 with the second exposure light EL2 which is emitted from the second illumination system IL2 and which is irradiated onto the second exposure area AR2 via the second pattern PA2 and the projection optical system PL. The projection optical system PL is commonly used to form both of the image of the first pattern PA1 formed in the first exposure area AR1 and the image of the second pattern PA2 formed in the second exposure area AR2.

The exposure apparatus EX of this embodiment multiple-exposes (double-exposes) a shot area S on the substrate P with the image of the first pattern PA1 formed in the first exposure area AR1 and the image of the second pattern PA2 formed in the second exposure area AR2.

The exposure apparatus EX of this embodiment is a scanning type exposure apparatus (so-called scanning stepper) in which the image of the first pattern PA1 of the first mask M1 and the image of the second pattern PA2 of the second mask M2 are projected onto the substrate P while synchronously moving the first mask M1, the second mask M2, and the substrate P in the predetermined scanning directions. In this embodiment, the scanning direction for the substrate P (synchronous movement direction) is the Y axis direction. The exposure apparatus EX multiple-exposes the shot area S on the substrate P with the image of the first pattern PA1 formed in the first exposure area AR1 and the image of the second pattern PA2 formed in the second exposure area AR2 by radiating, via the projection optical system PL, the first exposure light EL1 and the second exposure light EL2 onto the first exposure area AR1 and the second exposure area AR2 respectively while moving the shot area S of the substrate P in the Y axis direction with respect to the first exposure area AR1 and the second exposure area AR2. The exposure apparatus EX of this embodiment moves the first mask M1 in the Y axis direction and moves the second mask M2 in the Z axis direction in synchronization with the movement of the substrate P in the Y axis direction. That is, in this embodiment, the scanning direction for the first mask M1 (synchronous movement direction) is the Y axis direction, and the scanning direction for the second mask M2 (synchronous movement direction) is the Z axis direction.

The exposure apparatus EX of this embodiment is provided with a detecting system 30 which includes a light-receiving device 31 for receiving a detection light (detection light beam) via at least a part of the projection optical system PL and which obtains the information about the positional relationship among the image of the first pattern PA1, the image of the second pattern PA2, and the substrate P. In this embodiment, the light-receiving device 31 of the detecting system 30 is provided on a barrel PK of the projection optical system PL. The light-receiving device 31 receives, as the detection light or beams, a part or parts of at least one of the first exposure light EL1 and the second exposure light EL2 which are included in the first exposure light EL1 and the second exposure light EL2 coming into the optical element 20 via the first optical system 11 and the second optical system 12 and which do not travel from the optical element 20 to any one of the first exposure area AR1 and the second exposure area AR2, i.e., which travel in a direction or to an area (upper surface 35a of the light-receiving device 31 in this embodiment) different from the first exposure area AR1 and the second exposure area AR2. At least one optical element is arranged between the optical element 20 and the light-receiving device 31 in order to guide the light beam from the optical element 20 to the light-receiving device 31. However, such an optical element is omitted from the illustration in order to simplify the explanation.

The optical element 20 of this embodiment includes a polarization splitting optical element (for example, a polarizing beam splitter) which splits each of the first exposure light EL1 and the second exposure light EL2 into an exposure light with the first polarization and an exposure light with the second polarization. The projection optical system PL radiates a part of the first exposure light EL1 from the first pattern PA1 split by the optical element 20 and a part of the second exposure light EL2 from the second pattern PA2 split by the optical element 20 onto the first exposure area AR1 and the second exposure area AR2 respectively. The light-receiving device 31 receives, as the detection light or beams, a part or parts of at least one of the first exposure light EL1 and the second exposure light EL2 which are included in the first exposure light EL1 and the second exposure light EL2 which come into the optical element and which do not travel or are not directed from the optical element 20 to any one of the first exposure area AR1 and the second exposure area AR2.

At first, the first and second illumination systems IL1, IL2 will be explained. The first illumination system IL1 illuminates a first illumination area IA1 on the first mask M1 held by the first mask stage 1 with the first exposure light EL1 having a uniform illuminance distribution. An illumination optical system of the first illumination system IL1 includes, for example, a shaping optical system which varies the illumination condition, an illuminance-uniformizing member (for example, an internal reflection type integrator or a fly's eye lens) which uniformizes the illuminance distribution of the first exposure light EL1, a mask blind system (also referred to as "masking system" or "variable field diaphragm") which defines the first illumination area IA1, a relay optical system, and the like. Similarly, the second illumination system IL2 also includes, for example, a shaping optical system which varies the illumination condition, an illuminance-uniformizing member which uniformizes the illuminance distribution of the second exposure light EL2, a mask blind system which defines a second illumination area IA2, a relay optical system, and the like.

The shaping optical system provided in the first illumination system IL1 includes, for example, a diffraction optical element which is exchangeable, a plurality of prisms (axicons, etc.) of which intervals or spacing distances are variable, and a zoom optical system (afocal system). The intensity distribution of the first exposure light EL1 is changed on the pupil plane of the illumination optical system which is optically conjugate with the pupil plane of the projection optical system PL by at least one of the exchange of the diffraction optical element, the movement of the prism (change of the above-described interval or spacing distance), and the movement of the zoom optical system (in other words, the shape and/or the size of the secondary light source formed on the pupil plane of the illumination optical system is/are changed). With this, the illumination condition of the first mask M1 is changed. Therefore, the illumination optical system is capable of setting the illumination condition corresponding to the pattern of the first mask M1, and the illumination optical system is also capable of changing the illumination condition depending on the change of the pattern.

The mask blind system, which is provided for the first illumination system IL1, has at least a part thereof, for example, a plurality of independently movable light shielding plates (masking blades) arranged in a plane substantially optically conjugate with the surface of the first mask M1 in the illumination optical system. The size (width), etc. of the illumination area IA1 on the first mask M1 is changed by moving at least one of the plurality of light shielding plates. Therefore, the mask blind system can be used to adjust the size (width) of the first exposure area AR1 (projection area of the image of the first pattern PA1 conjugate with the first illumination area IA1 in relation to the projection optical system PL), etc. That is, it is possible to control the start and the end of the scanning exposure for the substrate effected by the first exposure light EL1 radiated onto the first exposure area AR1. Accordingly, any unnecessary exposure is avoided in any area other than one shot area on the substrate P to be subjected to the multiple exposure by one time of the scanning exposure operation. The unnecessary exposure may be avoided by controlling the light source device.

The second illumination system IL2 illuminates a second illumination area IA2 on the second mask M2 held by the second mask stage 2 with the second exposure light EL2 having a uniform illuminance distribution. Since the illumination system of the second illumination system IL2 is constructed in the same manner as the illumination optical system of the first illumination system IL1, any detailed explanation thereof is omitted. Parts of the first illumination system IL1 and the second illumination system IL2 (for example, the light source device and/or a part or parts of the illumination optical system) may be commonly used.

Those usable as the first and second exposure lights EL1, EL2 irradiated from the first and second illumination systems IL1, IL2 respectively include, for example, the far ultraviolet light beam (DUV light beam) such as the emission line (g-ray, h-ray, i-ray) radiated, for example, from a mercury lamp and the KrF excimer laser beam (wavelength: 248 nm), and the vacuum ultraviolet light beam (VUV light beam) such as the ArF excimer laser beam (wavelength: 193 nm) and the F₂ laser beam (wavelength: 157 nm). In this embodiment, the ArF excimer laser beam is used as the first and second exposure lights EL1, EL2.

The exposure apparatus EX of this embodiment includes a first light source device which corresponds to the first illumination system IL1, and a second light source device which corresponds to the second illumination system IL2. That is, the exposure apparatus EX of this embodiment has a plurality of light source devices (excimer laser light source devices). In this embodiment, the first illumination system IL1 illuminates the first pattern PA1 of the first mask M1 with the first exposure light EL1 with the first polarization, and the second illumination system IL2 illuminates the second pattern PA2 of the second mask M2 with the second exposure light EL2 with the second polarization. More specifically, in this embodiment, the first illumination system IL1 illuminates the first mask M1 with the first exposure light EL1 in which the P-polarized light component is the main component (for example, the P-polarized light component is not less than 90 %); and the second illumination system IL2 illuminates the second mask M2 with the second exposure light EL2 in which the S-polarized light component is the main component (for example, the S-polarized light component is not less than 90 %).

The exposure light radiated from one light source device may be divided or split into the first exposure light EL1 with the first polarization and the second exposure light EL2 with the second polarization, and the first exposure light EL1 and the second exposure light EL2 obtained in this way may be used to illuminate the first pattern PA1 and the second pattern PA2 therewith, respectively.

Next, the first mask stage 1 will be explained. The first mask stage 1 is movable at least in the X axis, Y axis, and θZ directions while holding the first mask M1 in accordance with the driving of a first mask stage-driving device 1D which includes an actuator such as a linear motor. The first mask stage 1 holds the first mask M1 so that a first pattern formation surface, on which the first pattern PA1 of the first mask M1 is formed, is substantially parallel to the XY plane. The position information about the first mask stage 1 (as well as the first mask M1) is measured by a laser interferometer 301 of the measuring system 3. The laser interferometer 301 measures the position information about the first mask stage 1 by using a reflecting surface 301K provided on the first mask stage 1. The controller 5 drives the first mask stage driving device 1D based on the measurement result obtained by the laser interferometer 301 to control the position of the first mask M1 held by the first mask stage 1.

Next, the second mask stage 2 will be explained. The second mask stage 2 is movable at least in the Z axis, X axis, and θY directions while holding the second mask M2 in accordance with the driving of a second mask stage-driving device 2D which includes an actuator such as a linear motor. The second mask stage 2 holds the second mask M2 so that a second pattern formation surface, on which the second pattern PA2 of the second mask M2 is formed, is substantially parallel to the XZ plane. The position information about the second mask stage 2 (as well as the second mask M2) is measured by a laser interferometer 302 of the measuring system 3. The laser interferometer 302 measures the position information about the second mask stage 2 by using a reflecting surface 302K provided on the second mask stage 2. The controller 5 drives the second mask stage driving device 2D based on the measurement result obtained by the laser interferometer 302 to control the position of the second mask M2 held by the second mask stage 2.

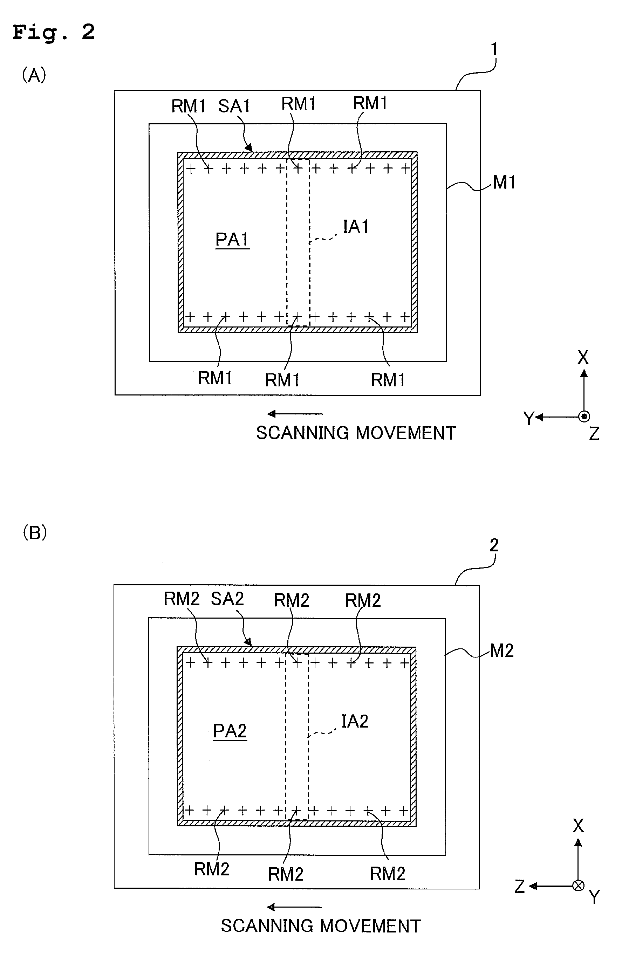

Fig. 2(A) is a plan view of the first mask M1 held by the first mask stage 1, and Fig. 2(B) is a plan view of the second mask M2 held by the second mask stage 2. As shown in Fig. 2, the first mask stage 1 holds the first mask M1 so that the first pattern formation surface, on which the first pattern PA1 of the first mask M1 is formed, is substantially parallel to the XY plane. The second mask stage 2 holds the second mask M2 so that the second pattern formation surface, on which the second pattern PA2 of the second mask M2 is formed, is substantially parallel to the XZ plane. The first illumination area IA1, formed by the first exposure light EL1 on the first mask M1, is defined to have a rectangular (slit-shaped) form in which the X axis direction is the longitudinal direction. The second illumination area IA2, formed by the second exposure light EL2 on the second mask M2, is also defined to have a rectangular (slit-shaped) form in which the X axis direction is the longitudinal direction.

The first mask stage 1 is capable of moving the first mask M1 having the first pattern PA1 in the Y axis direction with respect to the first exposure light EL1. The second mask stage 2 is capable of moving the second mask M2 having the second pattern PA2 in the Z axis direction with respect to the second exposure light EL2. Upon exposing one shot area on the substrate P, the controller 5 controls the first mask stage 1 to move the first mask M1 in the Y axis direction so that the first pattern formation area SA1, of the first mask M1, in which at least the first pattern PA1 is formed, passes across the first illumination area IA1 formed by the first exposure light EL1. Further, upon exposing one shot area on the substrate P, the controller 5 controls the second mask stage 2 to move the second mask M2 in the Z axis direction so that the second pattern formation area SA2, of the second mask M2, in which at least the second pattern PA2 is formed, passes across the second illumination area IA2 formed by the second exposure light EL2.

The first mask M1 is provided with a first alignment mark RM1 which is formed in a predetermined positional relationship with respect to the first pattern PA1. The second mask M2 is provided with a second alignment mark RM2 which is formed in a predetermined positional relationship with respect to the second pattern PA2. In this embodiment, each of the first and second alignment marks RM1, RM2 includes a two-dimensional mark, for example, a cross-shaped mark.

The first alignment mark RM1 is formed as a plurality of first alignment marks RM1 in a predetermined area in the first pattern formation surface of the first mask M1 on which the first pattern PA1 is formed. As shown in Fig. 2(A), the plurality of first alignment marks RM1 are formed and aligned in the scanning direction of the first mask M1 (Y axis direction) in each of the edge areas on the +X side and the -X side of the first pattern formation area SA1 of the first mask M1. Therefore, all of the first alignment marks RM1 are illuminated with the first exposure light EL1 from the first illumination system IL1 in accordance with the relative movement of the first illumination area IA1 and the first mask M1. The second alignment mark RM2 is formed as a plurality of second alignment marks RM2 in a predetermined area in the second pattern formation surface of the second mask M2 on which the second pattern PA2 is formed. As shown in Fig. 2(B), the plurality of second alignment marks RM2 are formed and aligned in the scanning direction of the second mask M2 (Z axis direction) in each of the edge areas on the +X side and the -X side of the second pattern formation area SA2 of the second mask M2. Therefore, all of the second alignment marks RM2 are illuminated with the second exposure light EL2 from the second illumination system IL2 in accordance with the relative movement of the second illumination area IA2 and the second mask M2. In this embodiment, the first alignment marks RM1 and the second alignment marks RM2 are formed on the first mask M1 and the second mask M2 respectively to correspond to one another. The numbers and the arrangements of the first and second alignment marks RM1, RM2 are not limited to those shown in Fig. 2. For example, the first and second alignment marks RM1, RM2 may be formed outside the first and second pattern formation surfaces, respectively.

Next, the projection optical system PL will be explained with reference to Fig. 1. The projection optical system PL projects the image of the first pattern PA1 of the first mask M1 illuminated with the first exposure light EL1 and the image of the second pattern PA2 of the second mask M2 illuminated with the second exposure light EL2 onto the substrate P at a predetermined projection magnification. The projection optical system PL of this embodiment is a reduction system in which the projection magnification is, for example, 1/4, 1/5, 1/8 or the like. A plurality of optical elements of the projection optical system PL are held or retained by the barrel PK.

The projection optical system PL of this embodiment includes a first optical system 11 which includes a plurality of optical elements and which guides the first exposure light EL1 from the first pattern PA1 to the optical element 20, a second optical system 12 which includes a plurality of optical elements and which guides the second exposure light EL2 from the second pattern PA2 to the optical element 20, and a third optical system 13 which includes a plurality of optical elements and which guides the first exposure light EL1 from the optical element 20 and the second exposure light EL2 from the optical element 20 to the first exposure area AR1 and the second exposure area AR2 respectively.

The optical element 20 has a first light-incident surface 21 into which the first exposure light EL1 comes from the first pattern PA1 of the first mask M1, and a second light-incident surface 22 into which the second exposure light EL2 comes from the second pattern PA2 of the second mask M2. The first exposure light EL1 from the first pattern PA1 of the first mask M1 comes into the first light-incident surface 21 of the optical element 20 via the first optical system 11. The second exposure light EL2 from the second pattern PA2 of the second mask M2 comes into the second light-incident surface 22 of the optical element 20 via the second optical system 12. That is, the first exposure light EL1 and the second exposure light EL2 come into the optical element 20 in the different directions (in the orthogonal or perpendicular directions in this embodiment). As described above, the optical element 20 is the polarization splitting optical element (polarizing beam splitter); the first exposure light EL1 with the first polarization is the exposure light mainly composed of the P-polarized light component; and the second exposure light EL2 with the second polarization is the exposure light mainly composed of the S-polarized light component. In this embodiment, a part of the first exposure light EL1 (P-polarized light component), coming from the first pattern PA1 into the optical element 20 via the first light-incident surface 21, is transmitted through a predetermined plane (polarization splitting plane) 25, and the part of the first exposure light EL1 exits from a first light-exit surface 23 of the optical element 20; and a part of the second exposure light EL2 (S-polarized light component), coming from the second pattern PA2 into the optical element 20 via the second light-incident surface 22, is reflected by the predetermined plane 25, and the part of the second exposure light EL2 exits from the first light-exit surface 23 of the optical element 20. That is, the part of the first exposure light EL1 and the part of the second exposure light EL2, coming into the optical element 20 in the different directions, exit from a same surface (first light-exit surface 23) of the optical element 20 in a same direction. In this case, the "P-polarized light component" is a linearly polarized light beam which is parallel to the light-incident surface of the incident light beam (first exposure light EL1) coming into the polarization splitting plane 25 (makes oscillation in the light-incident plane). The "S-polarized light component" is a linearly polarized light beam which is perpendicular to the light-incident surface of the incident light beam (second exposure light EL2) coming into the polarization splitting plane 25 (makes oscillation in the plane perpendicular to the light-incident plane). The first exposure light EL1 and the second exposure light EL2, which exit from the first light-exit surface 23, are radiated via the third optical system 13 onto the first exposure area AR1 and the second exposure area AR2 respectively.

On the other hand, the other part of the first exposure light EL1 (S-polarized light component), coming from the first pattern PA1 into the optical element 20 via the first light-incident surface 20, is not directed toward the first exposure area AR1, is reflected by the predetermined plane 25, and exits from a second light-exit surface 24 of the optical element 20. The other part of the second exposure light EL2 (P-polarized light component), coming from the second pattern PA2 into the optical element 20 via the second light-incident surface 22, is not directed toward the second exposure area AR2, is transmitted through the predetermined plane 25, and exits from the second light-exit surface 24 of the optical element 20. That is, the other part of the first exposure light EL1 and the other part of the second exposure light EL2, which come into the optical element 20 in the different directions, exit in a same direction from a same surface (second light-exit surface 24) of the optical element 20, and travel to the light-receiving device 31.

In the following description, the part of the first exposure light EL1 (P-polarized light component) and the part of the second exposure light EL2 (S-polarized light component), which exit from the first light-exit surface 23 of the optical element 20, are appropriately referred to as "first exposure light EL1 (P)" and "second exposure light EL2 (S)" respectively. The part of the first exposure light EL1 (S-polarized light component) and the part of the second exposure light EL2 (P-polarized light component), which exit from the second light-exit surface 24, are appropriately referred to as "first exposure light EL1 (S)" and "second exposure light EL2 (P)" respectively.

As shown in Fig. 1, the light-receiving device 31 of the detecting system 30 is arranged at a position capable of being irradiated with the first exposure light EL1 (S) and the second exposure light EL2 (P) which exit from the second light-exit surface 24 of the optical element 20. In this embodiment, the light-receiving device 31 is provided on the barrel PK of the projection optical system PL. However, the light-receiving device 31 may be provided on another member distinct from the projection optical system PL (barrel PK), for example, on a measuring frame (not shown) on which the alignment system 7, etc. is provided. The light-receiving device 31 is capable of receiving the first exposure light EL1 (S) and the second exposure light EL2 (P) which exit from the second light-exit surface 24 and which are not directed to any one of the first exposure area AR1 and the second exposure area AR2 from the optical element 20.

The exposure apparatus EX of this embodiment is provided with a first image formation characteristic-adjusting device LC1 and a second image formation characteristic-adjusting device LC2 which are capable of independently adjusting the image formation characteristics (image formation states) of the image of the first pattern PA1 and the image of the second pattern PA2 formed by the projection optical system PL respectively. Each of the first and second image formation characteristic-adjusting devices LC1, LC2 includes an optical element-driving mechanism which is capable of moving at least one of the plurality of optical elements of the projection optical system PL.

The first image formation characteristic-adjusting device LC1 is capable of moving at least one certain optical element of the first optical system 11 in the Z axis direction which is parallel to the optical axis of the first optical system 11 and in the directions (X axis and Y axis directions) which are perpendicular to the optical axis. Further, the first image formation characteristic-adjusting device LC1 is capable of inclining the certain optical element with respect to the XY plane which is perpendicular to the optical axis (i.e., capable of rotating the certain optical element in the θX and θY directions). The first exposure light EL1 from the first pattern PA1 is irradiated onto the first exposure area AR1 via the first optical system 11, the optical element 20, and the third optical system 13. The first image formation characteristic-adjusting device LC1 is capable of adjusting the image formation characteristic of the image of the first pattern PA1, formed with the first exposure light EL1 irradiated onto the first exposure area AR1, by driving the certain optical element of the first optical system 11.

The second image formation characteristic-adjusting device LC2 is capable of moving at least one certain optical element of the second optical system 12 in the Y axis direction which is parallel to the optical axis of the second optical system 12 and in the directions (X axis and Z axis directions) which are perpendicular to the optical axis. Further, the second image formation characteristic-adjusting device LC2 is capable of inclining the certain optical element with respect to the XZ plane which is perpendicular to the optical axis (i.e., capable of rotating the certain optical element in the θX and θZ directions). The second exposure light EL2 from the second pattern PA2 is irradiated onto the second exposure area AR2 via the second optical system 12, the optical element 20, and the third optical system 13. The second image formation characteristic-adjusting device LC2 is capable of adjusting the image formation characteristic of the image of the second pattern PA2, formed with the second exposure light EL2 irradiated onto the second exposure area AR2, by driving the certain optical element of the second optical system 12.

The first and second image formation characteristic-adjusting devices LC1, LC2 are controlled by the controller 5. The controller 5 uses the first and second image formation characteristic-adjusting devices LC1, LC2 to drive the certain optical elements of the projection optical system PL (first and second optical systems 11, 12), thereby making it possible to adjust the image formation characteristic including various aberrations of the projection optical system PL (for example, the distortion, the astigmatic aberration, the spherical aberration, and the wave aberration), the projection magnification, the image plane position (focus position), etc.

The controller 5 uses the first and second image formation characteristic-adjusting devices LC1, LC2 to thereby making it also possible to perform the positional adjustment for the images of the first and second patterns PA1, PA2 in the XY direction and/or the θZ direction (i.e., the shift adjustment and/or the rotation adjustment).

That is, the controller 5 is capable of performing the adjustment of the state (for example, the size and the distortion) of each of the first and second patterns PA1, PA2, the positional adjustment in the Z axis direction for the image plane of the projection optical system PL on which each of the images of the first and second patterns PA1, PA2 is formed, and the inclination adjustment in the θX and θY directions, as well as the positional adjustment for each of the images of the first and second patterns PA1, PA2 in the X axis direction, the Y axis direction, and the θZ direction by using the first and second image formation characteristic-adjusting devices LC1, LC2.

In this embodiment, at least one optical element of each of the first and second optical systems 11, 12, which is moved by one of the first and second image formation characteristic-adjusting devices LC1, LC2, is not limited to the lens, and may be any other optical element including, for example, a plane-parallel and a reflecting element. Further, although the two image formation characteristic-adjusting devices (LC1, LC2) are provided in this embodiment, it is also allowable to provide only one image formation characteristic-adjusting device or it is also allowable to provide three or more image formation characteristic-adjusting devices. For example, it is also allowable to provide an image formation characteristic-adjusting device which is capable of moving at least one optical element of the third optical system 13 in the Z axis direction that is parallel to the optical axis of the third optical system and the X axis and Y axis directions and which is capable of rotating at least one optical element of the third optical system 13 in the θX and θY directions. In this embodiment, the first image formation characteristic-adjusting device LC1 moves the optical element in the directions of five degrees of freedom, i.e., in the X axis, Y axis, Z axis, θX and θY directions, and the second image formation characteristic-adjusting device LC2 moves the optical element in the directions of five degrees of freedom, i.e., in the X axis, Y axis, Z axis, θX and θZ directions. However, the directions of movement of the optical element are not limited to the directions of five degrees of freedom. Further although this embodiment adopts such a system that the image formation characteristic-adjusting device moves the optical element, any other system may be used in place thereof or in combination therewith. For example, a pressure-adjusting mechanism, which adjusts the pressure of a gas in a space between parts of the optical elements held in the barrel PK, may be used as each of the first and second image formation characteristic-adjusting devices LC1, LC2.

The exposure apparatus, which is provided with the image formation characteristic-adjusting device capable of adjusting the image formation characteristic of the image of the pattern formed by the projection optical system, is disclosed, for example, in Japanese Patent Application Laid-open No. 60-78454 (corresponding to United States Patent No. 4,666,273), Japanese Patent Application Laid-open No. 11-195602 (corresponding to United States Patent No. 6,235,438), and International Publication No. 03/65428 (corresponding to United States Patent Application Publication No. 2005/020685), etc.

Next, the substrate stage 4 will be explained. The substrate stage 4 is movable while holding the substrate P in a predetermined area including the first exposure area AR1 and the second exposure area AR2 onto which the first exposure light EL1 and the second exposure light EL2 are radiated. As shown in Fig. 1, the substrate stage 4 includes a substrate holder 4H which is supported in a non-contact manner over or above the base member BP by, for example, an air bearing and which holds the substrate P. The substrate holder 4H holds the substrate P so that the surface of the substrate P is substantially parallel to the XY plane. The substrate stage 4 is capable of moving the substrate P in the directions of six degrees of freedom of the X axis, Y axis, Z axis, θX, θY, and θZ directions in accordance with the driving of the substrate stage-driving device 4D including, for example, an actuator such as a linear motor.

The position information about the substrate stage 4 (as well as the substrate P) is measured by a laser interferometer 304 of the measuring system 3. The laser interferometer 304 measures the position information of the substrate stage 4 in relation to the X axis, Y axis, and θZ directions by using a reflecting surface 304K which is provided on the substrate stage 4. The surface position information (position information in relation to the Z axis, θX, and θY directions) of the surface of the substrate P held by the substrate stage 4 is detected by an unillustrated focus/leveling-detecting system. The controller 5 drives the substrate stage-driving device 4D based on the result of measurement performed by the laser interferometer 304 and the result of detection performed by the focus/leveling-detecting system to control the position of the substrate P held by the substrate stage 4. As for the focus/leveling-detecting system, it is possible to use a multi-point position-detecting system which measures the position information in the Z axis direction of the substrate P at a plurality of measuring points respectively to detect the surface position information as disclosed, for example, in United States Patent No. 6,608,681. In this embodiment, at least a part of the plurality of measuring points is defined in each of the first and second exposure areas AR1, AR2. However, for example, in the case of a liquid immersion exposure apparatus as described later on, all of the measuring points may be defined at the outside of the first and second exposure areas AR1, AR2 (or at the outside of the liquid immersion area). The laser interferometer 304 may be also capable of measuring the position information in the Z axis, θX, and θY directions of the substrate stage 4, details of which are disclosed, for example, in Published Japanese Translation of PCT International Publication for Patent Application No. 2001-510577 (corresponding to International Publication No. 1999/28790). In this case, it is also allowable that the focus/leveling-detecting system is not provided. Alternatively, it is also allowable that the focus/leveling-detecting system is not necessarily provided such that the plurality of measuring points are arranged inside and/or outside the first and second exposure areas AR1, AR2. For example, the focus/leveling-detecting system may be provided separately from the projection optical system PL.

At least a part of a spatial image-measuring device 162 as disclosed for example in Japanese Patent Application Laid-open No. 2002-14005 (corresponding to United States Patent Application Publication No. 2002/0041377), is provided on the substrate stage 4. The controller 5 is capable of obtaining, by using the spatial image-measuring device 162, at least one of the position information about the image of the first pattern PA1 formed in the first exposure area AR1 and the position information about the image of the second pattern PA2 formed in the second exposure area AR2 in the XY coordinate system defined by the measuring system 3. In this embodiment, at least one of the images of the first and second alignment marks RM1, RM2 of the first and second masks M1, M1 is detected by the spatial image-measuring device 162. Therefore, it is possible to determine at least one of the projection positions of the first and second patterns PA1, PA2 in the XY coordinate system.

As shown in Fig. 1, the exposure apparatus EX of this embodiment is provided with the alignment system 7 which detects a reference mark FP provided on the substrate stage 4 and an alignment mark AM provided on the substrate P. The alignment system 7 is an alignment system of the off-axis system provided in the vicinity of the projection optical system PL, and is an alignment system of the FIA (Field Image Alignment) system as disclosed, for example, in Japanese Patent Application Laid-open No. 4-65603 (corresponding to United States Patent No. 5,493,403) and United States Patent No. 5,646,413, wherein a broadband detecting light flux, which does not photosensitize the photosensitive material on the substrate P, is radiated onto an objective mark (for example, the alignment mark AM formed on the substrate P and the reference mark FP formed on the substrate stage 4); an image of the objective mark formed on the light-receiving surface by the reflected light beam from the objective mark and an image of an index (index mark formed on an index plate provided in the alignment system 7) are imaged by using an image pickup element (CCD or the like); and their image pickup signals are subjected to an image processing to measure the position of the mark thereby. The index defines a detection reference position of the alignment system 7 in the XY coordinate system defined by the measuring system 3. The alignment system 7 detects a positional relationship (positional deviation) between the image of the detection objective mark and the index. The controller 5 is capable of detecting the position (coordinate value) of the detection objective mark in the XY coordinate system defined by the measuring system 3 based on the detected positional relationship and the position information about the substrate stage 4 obtained from the measuring system 3 upon the mark detection performed by the alignment system 7. The baseline amount of the alignment system 7, i.e., the distance between the detection reference position of the alignment system 7 in the XY coordinate system and the projection position of at least one of the images of the first and second patterns PA1, PA2 is determined by the detection of at least one of the images of the first and second alignment marks RM1, RM2 of the first and second masks M1, M2 performed by the spatial image-measuring device 162 and the detection of the reference mark FP performed by the alignment system 7. The baseline amount is stored in the storage device 6. In this embodiment, each of the alignment mark AM of the substrate P and the reference mark FP includes two-dimensional marks, for example, two periodic marks arranged periodically in the X axis direction and the Y axis direction respectively.

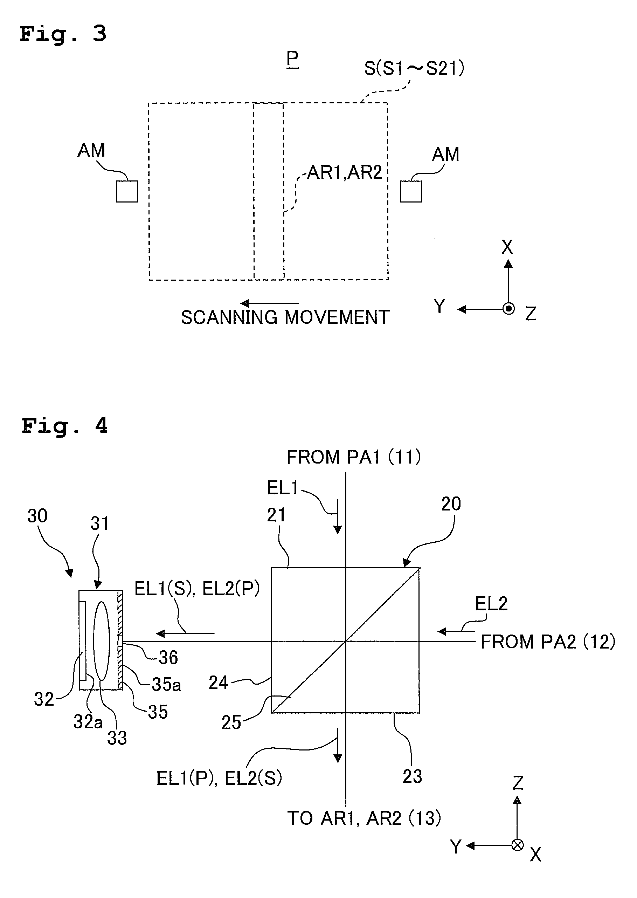

Fig. 3 schematically shows the positional relationship between the shot area S on the substrate P and the first and second exposure areas AR1, AR2. As shown in Fig. 3, the first exposure area AR1, which is formed by the first exposure light EL1 on the substrate P, is defined to have a rectangular (slit-shaped) form in which the X axis direction is the longitudinal direction. The second exposure area AR2, which is formed by the second exposure light EL2 on the substrate P, is also defined to have a rectangular (slit-shaped) form in which the X axis direction is the longitudinal direction. As described above, in this embodiment, the first exposure area AR1 irradiated with the first exposure light EL1 and the second exposure area AR2 irradiated with the second exposure light EL2 are overlaid or superimposed (coincident with each other). An example of the alignment marks AM, which are provided to detect the position information about the shot area S on the substrate P, is also shown in Fig. 3. In this embodiment, although the alignment marks AM are formed on the both sides of the shot area S in the Y axis direction respectively, the number and the position of the alignment mark or alignment marks AM are not limited thereto.

The substrate stage 4 is capable of moving the shot area S on the substrate P in the Y axis direction with respect to the first exposure area AR1 and the second exposure area AR2. Upon exposing the substrate P, the controller 5 controls the substrate stage 4 to move the substrate P in the Y axis direction so that the shot area S on the substrate P passes across the first and second exposure areas AR1, AR2 formed by the first and second exposure lights EL1, EL2.

Next, the detecting system 30 will be explained. Fig. 4 shows a schematic construction of the detecting system 30. The detecting system 30 is provided in order to obtain the information about the positional relationship among the image of the first pattern PA1, the image of the second pattern PA2, and the shot area S on the substrate P. The detecting system 30 is provided with the light-receiving device 31 which is capable of receiving a part of at least one of the first exposure light EL1 and the second exposure light EL2 via at least a part of the projection optical system PL. In this embodiment, the light-receiving device 31 receives the first exposure light EL1 (S) and the second exposure light EL2 (P) which exit from the second light-exit surface 24 of the optical element 20 and which do not travel to any one of the first exposure area AR1 and the second exposure area AR2, as the detection lights to obtain the information about the positional relationship described above.

With reference to Fig. 4, the light-receiving device 31 includes a plate member 35 in which a transmitting portion (aperture) 36 is formed through which the first exposure light EL1 (S) and the second exposure light EL2 (P) can be transmitted; and a light-receiving element 32 which receives the light beam, passing through the transmitting portion 36 (first position) of the plate member 35, via a predetermined optical system 33. The first and second exposure lights EL1 (S), EL2 (P) exit from the second light-exit surface 24 of the optical element 20, and are irradiated onto a light-receiving surface 32a of the light-receiving element 32 via the optical system 33 of the light-receiving device 31.

The plate member 35 is formed of, for example, silica glass through which the first and second exposure lights EL1 (S), EL2 (P) are transmissive. The transmitting portion 36 has the aperture which is formed in the light-shielding area formed of, for example, a metal such as Cr (chromium) on the upper surface 35a of the plate member 35. The transmitting portion 36 is provided at each of two positions separated from each other in the X axis direction in conformity with the arrangement of the alignment marks RM1, RM2. The light beam, passing through the transmitting portion (aperture) 36 of the plate member 35, is received by the light-receiving element 32 via the optical system 33. The light-receiving element 32 includes a photoelectric conversion element including, for example, an image pickup element (CCD, etc.) and a photomultiplier tube (PMT, photomultiplier).

The upper surface 35a of the plate member 35 of the light-receiving device 31 is arranged at a position (or in the vicinity thereof) which is optically conjugate with the image plane (not shown) and the object plane (not shown) of the projection optical system PL. That is, the upper surface 35a of the plate member 35 of the light-receiving device 31 is arranged at the position (or in the vicinity thereof) which is optically conjugate with the first and second pattern formation surfaces of the first and second masks M1, M2 and the surface of the substrate P. The upper surface 35a of the plate member 35 of the light-receiving device 31 and the light-receiving surface 32a of the light-receiving element 32 are optically conjugate with each other via the optical system 33. Therefore, the first exposure light EL1 (S) and the second exposure light EL2 (P) are allowed to come into the upper surface 35a of the plate member 35 in a positional relationship which is same as or equivalent to that of the first exposure area AR1 and the second exposure area AR2.

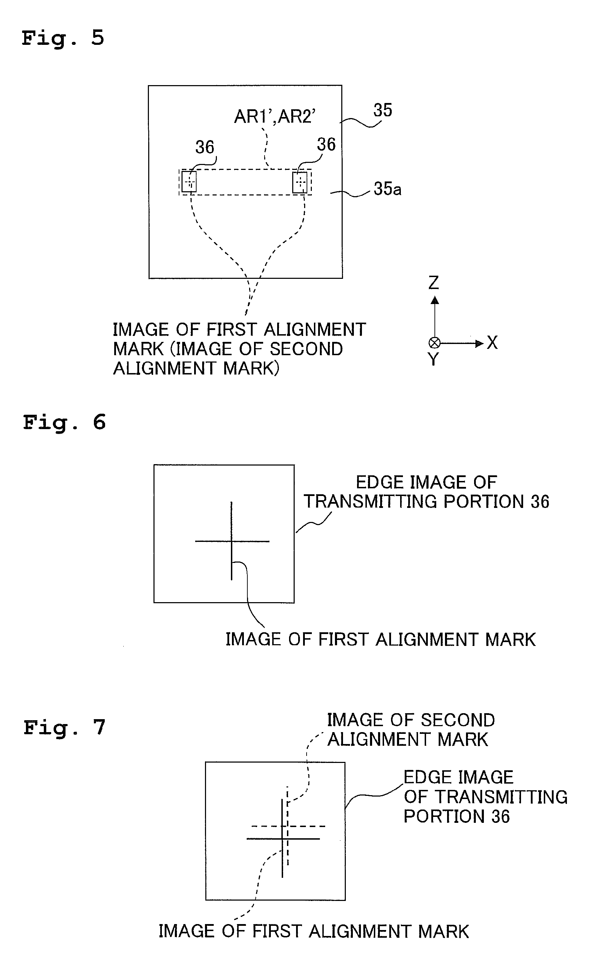

Fig. 5 shows the upper surface 35a of the plate member 35 of the light-receiving device 31. When the first and second exposure lights EL1, EL2 are irradiated from the first and second illumination systems IL1, IL2 and come into the projection optical system PL, then the first exposure light EL1 (S) and the second exposure light EL2 (P) come into the upper surface 35a of the plate member 35. As shown in Fig. 3, in this embodiment, the first exposure area AR1 and the second exposure area AR2 are overlaid or superimposed with each other on the image plane of the projection optical system PL. Therefore, an area AR1' irradiated with the first exposure light EL1 (S) and an area AR2' irradiated with the second exposure light EL2 (P) are formed so as to be overlaid or superimposed with each other on the upper surface 35a of the plate member 35 arranged at the position optically conjugate with the image plane and the object plane of the projection optical system PL.

In the following description, the area AR1', which is irradiated with the first exposure light EL1 on the upper surface 35a of the plate member 35 of the light-receiving device 31, is appropriately referred to as "first detection light area AR1'", and the area AR2', which is irradiated with the second exposure light EL2, is appropriately referred to as "second detection light area AR2'".

As described above, the upper surface 35a of the plate member 35 is arranged at the position (or in the vicinity thereof) which is optically conjugate with the image plane and the object plane of the projection optical system PL. Therefore, the image of the first pattern PA1 is formed in the first detection light area AR1' by the first exposure light EL1 (S) which is irradiated onto the first detection light area AR1' on the upper surface 35a of the plate member 35, and the image of the second pattern PA2 is formed in the second detection light area AR2' by the second exposure light EL2 (P) which is irradiated onto the second detecting light area AR2' on the upper surface 35a.

As explained with reference to Fig. 2, in this embodiment, the first alignment mark RM1 on the first mask M1 can be arranged inside the first illumination area IA1. Therefore, the first alignment mark RM1 can be illuminated with the first exposure light EL1 from the first illumination system IL1. Further, the second alignment mark RM2 on the second mask M2 can be arranged inside the second illumination area IA2. Therefore, the second alignment mark RM2 can be illuminated with the second exposure light EL2 from the second illumination system IL2. Therefore, the image of the first alignment mark RM1 is also formed in the first detection light area AR1' on the upper surface 35a of the plate member 35, and the image of the second alignment mark RM2 is also formed in the second detecting area AR2' on the upper surface 35a of the plate member 35. That is, in this embodiment, the image of the first alignment mark RM1 and the image of the second alignment mark RM2 are formed on the upper surface 35a of the plate member 35 via the optical element 20 of the projection optical system PL, etc.

As shown in Fig. 5, the transmitting portions 36 of the light-receiving device 31 are arranged on the upper surface 35a of the plate member 35 at the positions (two positions) at which the image of the first alignment mark RM1 and the image of the second alignment mark RM2 can be formed. As described above, the light-receiving surface 32a of the light-receiving element 32 is arranged at the position which is conjugate with the transmitting portion of the plate member 35 with respect to the optical system 33. Therefore, the images of the first and second patterns PA1, PA2 are not formed on the light-receiving surface 32a of the light-receiving device 31 on which only at least one of the images of the first alignment mark RM1 and the second alignment mark RM2 can be formed.

As described above, in this embodiment, the light-receiving device 31 (light-receiving element 32) receives, as the detection lights, the first exposure light EL1 (S) from the first alignment mark RM1 and the second exposure light EL2 (P) from the second alignment mark RM2 via a part of the projection optical system PL including the optical element 20.

Fig. 6 schematically shows an example of a state that the image of the first alignment mark RM1 is formed on the light-receiving surface 32a. As shown in Fig. 6, the images of four edges of the transmitting portion (aperture) 36 of the plate member 35 are formed in a rectangular form on the light-receiving surface 32a of the light-receiving device 31 of the detecting system 30 of this embodiment. The image of the first alignment mark RM1 is formed inside the edge image of the transmitting portion 36. The transmitting portion 36 (edge image of the transmitting portion 36) is provided as a reference to be used when the position information about the images of the first and second patterns PA1, PA2 is determined. The first pattern PA1 and the first alignment mark RM1 on the first mask M1 are formed in the predetermined positional relationship. Further, the positional relationship between the image of the first alignment mark RM1 and the edge image of the transmitting portion 36 is previously correlated or associated with the projection position of the first alignment mark RM1 in the first exposure area AR1 (projection position of the image of the first pattern) as described later on. Therefore, as described later on, by determining the positional relationship between the edge image of the transmitting portion 36 and the image of the first alignment mark RM1 formed via the part of the projection optical system PL on the light-receiving surface 32a of the light-receiving element 32, it is possible to obtain the image of the first alignment mark RM1 formed in the first exposure area AR1 as well as the position information (for example, the information about the positional deviation from a target position) about the image of the first pattern PA1 and/or the position information about the first pattern PA1 (first mask M1). That is, the controller 5 is capable of obtaining the position information about the image of the first pattern PA1 formed in the first exposure area AR1 and/or the position information about the first pattern PA1 (first mask M1) based on the light-receiving result of the light-receiving device 31. The position information obtained by the controller 5 includes not only the position information in relation to the X axis direction and the Y axis direction but also the information about the rotation.

Similarly, the controller 5 is capable of obtaining the position information about the image of the second pattern PA2 formed in the second exposure area AR2 and/or the position information about the second pattern PA2 (second mask M2) based on the light-receiving result of the light-receiving device 31 (positional relationship between the edge image of the transmitting portion 36 and the image of the second alignment mark RM2 formed on the light-receiving surface 32a of the light-receiving element 32).

Further, the controller 5 is also capable of obtaining at least one of the positional relationship between the image of the first pattern and the image of the second pattern formed in the exposure areas (AR1, AR2) and the positional relationship between the first pattern PA1 (first mask M1) and the second pattern PA2 (second mask M2) based on the light-receiving result of the light-receiving device 31.

As shown in Fig. 6, in order to form only the image of the first alignment mark RM1 without forming the image of the second alignment mark RM2 on the light-receiving surface 32a, the controller 5 may illuminate the first alignment mark RM1 with the first exposure light EL1 from the first illumination system IL1 in a state that the irradiation of the second exposure light EL2 from the second illumination system IL2 is stopped.

On the other hand, in order to determine the position information about the image of the second pattern PA2 formed on the light-receiving surface 32a by forming only the image of the second alignment mark RM2 without forming the image of the first alignment mark RM1 on the light-receiving surface 32a, the controller 5 may illuminate the second alignment mark RM2 with the second exposure light EL2 from the second illumination system IL2 in a state that the irradiation of the first exposure light EL1 from the first illumination system IL1 is stopped.

It is also allowable that the image of the first alignment mark RM1 and the image of the second alignment mark RM2 are simultaneously formed on the light-receiving surface 32a of the light-receiving element 32.

Fig. 7 schematically shows an example of a state that the image of the first alignment mark RM1 and the image of the second alignment mark RM2 are formed on the light-receiving surface 32a of the light-receiving element 32. As shown in Fig. 7, the image of the first pattern PA1 and the image of the second pattern PA2 are formed on the light-receiving surface 32a. The detecting system 30 is capable of determining the positional relationship between the image of the first alignment mark RM1 and the edge image of the transmitting portion 36 and the positional relationship between the image of the second alignment mark RM2 and the edge image of the transmitting portion 36 based on the light-receiving result of the light-receiving device 31, the images being formed via the part of the projection optical system PL on the light-receiving surface 32a of the light-receiving device 31. The first pattern PA1 and the first alignment mark RM1 on the first mask M1 are formed in the predetermined positional relationship, and the second pattern PA2 and the second alignment mark RM2 on the second mask M2 are formed in the predetermined positional relationship. Therefore, the controller 5 is capable of determining at least one of the position information about the image of the first pattern PA1 formed in the first exposure area AR1, the position information about the image of the second pattern PA2 formed in the second exposure area AR2, the positional relationship between the image of the first pattern PA1 and the second pattern PA2 in the exposure areas (AR1, AR2), the position information about the first pattern PA1, the position information about the second pattern PA2, and the positional relationship between the first pattern PA1 and the second pattern PA2 based on the light-receiving result of the light-receiving device 31.

In a case that the image of the first alignment mark RM1 and the image of the second alignment mark RM2 are simultaneously formed on the light-receiving surface 32a of the light-receiving device 31, it is also allowable that the shape of the first alignment mark RM1 and the shape of the second alignment mark RM2 are made to be different from each other so that the image of the first alignment mark RM1 and the second alignment mark RM2 can be independently detected with ease.

As shown in Fig. 7, in order to form the image of the first alignment mark RM1 and the image of the second alignment mark RM2 on the light-receiving surface 32a respectively, the controller 5 may illuminate the first alignment mark RM1 with the first exposure light EL1 from the first illumination system IL1, and the controller 5 may illuminate the second alignment mark RM2 with the second exposure light EL2 from the second illumination system IL2.

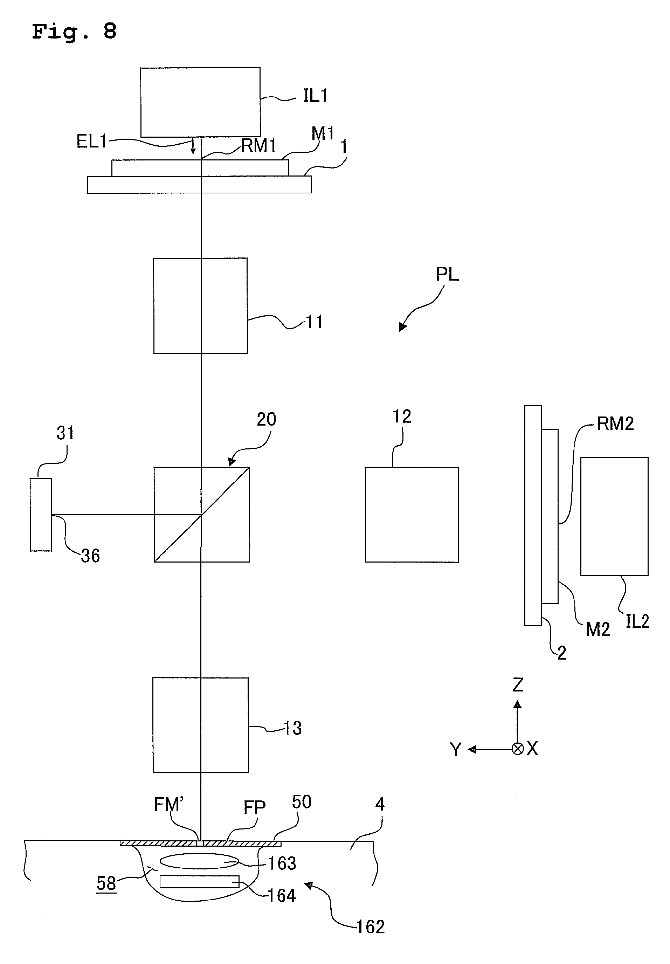

Next, the spatial image-measuring device 162 will be explained. Fig. 8 shows the spatial image-measuring device 162. The controller 5 uses the spatial image-measuring device 162 to thereby make it possible to measure the position information about the image of the first pattern PA1 formed in the first exposure area AR1 and the position information about the image of the second pattern PA2 formed in the second exposure area AR2. In this embodiment, at least a part of the spatial image-measuring device 162 is provided in the substrate stage 4 which can be arranged on the image plane side of the projection optical system PL. As shown in Fig. 8, in this embodiment, a reference plate 50, which has a transmitting portion (aperture) FM', through which a light (light beam) can be transmitted, is provided on the substrate stage 4. An internal space 58 of the substrate stage 4 is defined under or below the reference plate 50 (in the -Z direction). A part, of the spatial image-measuring device 162 which receives the detection light radiated from the projection optical system PL onto the substrate stage 4, is provided in the internal space 58. The spatial image-measuring device 162 is provided with an optical system 163 which is disposed under or below the reference plate 50, and a light-receiving element 164 which receives the light beam via the optical system 163.

The reference plate 50 is formed of, for example, silica glass through which the first exposure light EL1 (P) and the second exposure light EL2 (S) are transmissive. The transmitting portion FM' has a cross-shaped aperture (slit) which is formed in a light-shielding area formed of, for example, a metal such as Cr (chromium). The light beam, which is radiated onto the transmitting portion (aperture) FM' of the reference plate 50, is received by the light-receiving element 164 via the optical system 163. The transmitting portion FM' (second position) is provided as a reference to be used when the position information about the images of the first and second patterns PA1, PA2 is determined. In the following explanation, the transmitting portion FM' is appropriately referred to as "reference transmitting portion FM'".

Although not shown, a reference mark FP, which is detected by the alignment system 7, is formed on the reference plate 50. The reference transmitting portion FM' and the reference mark FP are provided in a predetermined positional relationship.

Next, an explanation will be made about an example of an operation for measuring the position information about the image of the first pattern PA1 by using the spatial image-measuring device 162. The controller 5 moves the substrate stage 4 in the XY direction so that the reference transmitting portion FM' on the substrate stage 4 is arranged in the first exposure area AR1. The controller 5 radiates the first exposure light EL1 as the detection light from the first illumination system IL1 onto the first alignment mark RM1 of the first mask M1. As described above, the first alignment mark RM1 can be arranged in the first illumination area IA1. The first illumination system IL1 can illuminate, with the first exposure light EL1, the first alignment mark RM1 arranged in the first illumination area IA1. The controller 5 measures the spatial image of the first alignment mark RM1 illuminated with the first exposure light EL1 via the projection optical system PL by the spatial image-measuring device 162, while measuring the position information about the substrate stage 4 by using the measuring system 3. As described above, in this embodiment, the first exposure area AR1 and the second exposure area AR2 are overlaid with each other. When the spatial image of the first alignment mark RM1 is measured, the controller 5 stops the irradiation of the second exposure light EL2 from the second illumination system IL2. With this, the spatial image-measuring device 162 can detect the positional relationship between the reference transmitting portion FM' on the reference plate 50 and the first alignment mark RM1 on the first mask M1. The first pattern PA1 on the first mask M1 and the first alignment mark RM1 are formed in the predetermined positional relationship. Therefore, the controller 5 can determine the positional relationship between the first pattern PA1 and the reference transmitting portion FM', and the controller 5 can determine the positional relationship between the reference transmitting portion FM' and the projection position of the image of the first pattern PA1 formed in the first exposure area AR1. That is, the controller 5 can determine the position information about the image of the first pattern PA1 formed in the first exposure area AR1 based on the measurement result of the spatial image-measuring device 162.

The image of the first alignment mark RM1 is also formed on the light-receiving surface 32a of the light-receiving device 31 during the measurement performed by the spatial image-measuring device 162. As explained with reference to Fig. 6, etc., the controller 5 can determine the positional relationship between the edge image of the transmitting portion 36 and the image of the first alignment mark RM1 formed on the light-receiving surface 32a of the light-receiving device 31 based on the detection result of the detecting system 30. Further, as described above, the controller 5 can determine the positional relationship between the reference transmitting portion FM' and the image of the fist alignment mark RM1 formed in the first exposure area AR1 and the positional relationship between the reference transmitting portion FM' and the image of the first pattern PA1 formed in the first exposure area AR1, based on the measurement result of the spatial image-measuring device 162. Therefore, the controller 5 can correlate the position information about the image of the first alignment mark RM1 formed on the light-receiving surface 32a as the detection result of the detecting system 30 (positional relationship between the image of the first alignment mark RM1 and the edge image of the transmitting portion 36) and the position information about the image of the first pattern PA1 formed in the first exposure area AR1 as the measurement result of the spatial image-measuring device 162.

Therefore, the controller 5 can obtain the position information about the image of the first pattern PA1 formed in the first exposure area AR1 and/or the position information about the first pattern PA1, based on the output of the light-receiving device 31 of the detecting system 30.

Similarly, the controller 5 can correlate the position information about the image of the second alignment mark RM2 formed on the light-receiving surface 32a as the detection result of the detecting system 30 (positional relationship between the image of the second alignment mark RM2 and the edge image of the transmitting portion 36) and the position information about the image of the second pattern PA2 formed in the second exposure area AR2 as the measurement result of the spatial image-measuring device 162.

Therefore, the controller 5 can obtain the position information about the image of the second pattern PA2 formed in the second exposure area AR2 and/or the position information about the second pattern PA2, based on the output of the light-receiving device 31 of the detecting system 30. Therefore, the controller 5 can also determine the positional relationship between the image of the first pattern PA1 and the image of the second pattern PA2 in the exposure areas (AR1, AR2) based on the output of the light-receiving device 31 of the detecting system 30.

Any certain first alignment mark RM1 of the plurality of first alignment marks RM1 can be used as the first alignment mark RM1 to be used when the position information about the image of the first pattern PA1 (position information about the first pattern PA1) is obtained by using the spatial image-measuring device 162. Alternatively, another measuring mark, which is distinct from the first alignment mark RM1, may be provided on the first mask M1, and the measuring mark may be used. Similarly, any certain second alignment mark RM2 of the plurality of second alignment marks RM2 can be used as the second alignment mark RM2 to be used when the position information about the image of the second pattern PA2 (position information about the second pattern PA2) is obtained. Alternatively, another measuring mark, which is distinct from the second alignment mark RM2, may be provided on the second mask M2, and the measuring mark may be used. That is, it is enough that a mark to be used for the measurement by the spatial image-measuring device 162 is formed in the predetermined positional relationships with respect to the first and second alignment marks RM1, RM2 of which images are formed on the light-receiving surface 32a of the light-receiving device 31. This also holds for the detecting system 30 similarly.

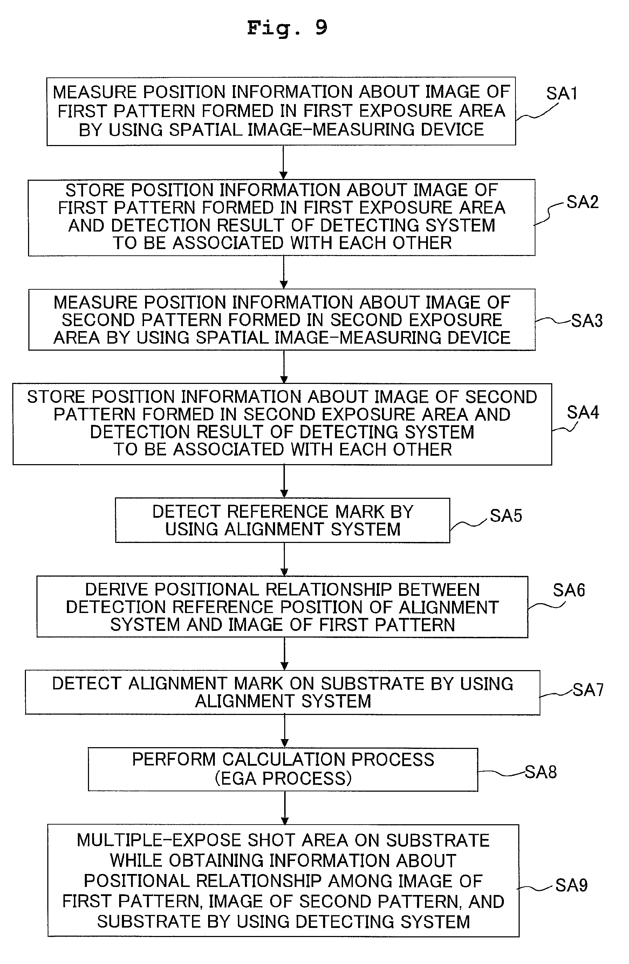

Next, an explanation will be made with reference to Fig. 9 about a method for exposing the substrate P by using the exposure apparatus EX constructed as described above. Fig. 9 shows a flow chart illustrating the exposure method according to this embodiment.

At first, the controller 5 obtains the position information about the image of the first pattern PA1 formed in the first exposure area AR1 by using the spatial image-measuring device 162 (Step SA1) as explained with reference to Fig. 8, etc., before the exposure is started for the substrate P. As described above, when the first exposure light EL1 (P) is radiated onto the reference plate 50 in order to obtain the position information about the image of the first pattern PA1 by the spatial image-measuring device 162, the first exposure light EL1 (S) is radiated also onto the light-receiving surface 32a of the light-receiving device 31 of the detecting system 30. The detecting system 30 detects the positional relationship between the edge image of the transmitting portion 36 and the image of the first alignment mark RM1 formed on the light-receiving surface 32a. As described above, the controller 5 correlates the position information about the image of the first pattern PA1 formed in the first exposure area AR1 and the detection result of the detecting system 30 based on the measurement result of the spatial image-measuring device 162 and the detection result of the detecting system 30. The controller 5 stores, in the storage device 6, the relationship between the detection result of the detecting system 30 and the position information about the image of the first pattern PA1 formed in the first exposure area AR1 (Step SA2). In the following process, the controller 5 can obtain the position information about the image of the first pattern PA1 formed in the first exposure area AR1 based on the output of the light-receiving device 31 of the detecting system 30 and the information stored in the storage device 6. That is, the controller 5 can obtain, by performing the detecting operation by the detecting system 30, the position information about the image of the first pattern PA1 formed in the first exposure area AR1 based on the detection result of the detecting system 30 (light-receiving result of the light-receiving device 31) and the information stored in the storage device 6, without performing the measuring operation for measuring the position information about the image of the first pattern PA1 formed in the first exposure area AR1 (measuring operation using the spatial image-measuring device 162).

On the other hand, the controller 5 obtains the position information about the image of the second pattern PA2 formed in the second exposure area AR2 by using the spatial image-measuring device 162 (Step SA3) as explained with reference to Fig. 8, etc. As described above, when the second exposure light EL2 is radiated onto the reference plate 50 in order to obtain the position information about the image of the second pattern PA2 by the spatial image-measuring device 162, the second exposure light EL2 is radiated also onto the light-receiving surface 32a of the light-receiving device 31 of the detecting system 30. The detecting system 30 detects the positional relationship between the edge image of the transmitting portion 36 and the image of the second alignment mark RM2 formed on the light-receiving surface 32a. As described above, the controller 5 correlates the position information about the image of the second pattern PA2 formed in the second exposure area AR2 and the detection result of the detecting system 30. The controller 5 stores, in the storage device 6, the relationship between the detection result of the detecting system 30 and the position information about the image of the second pattern PA2 formed in the second exposure area AR2 (Step SA4). In the following process, the controller 5 can obtain the position information about the image of the second pattern PA2 formed in the second exposure area AR2 based on the output of the light-receiving device 31 of the detecting system 30 and the information stored in the storage device 6. That is, the controller 5 can obtain, by performing the detecting operation by the detecting system 30, the position information about the image of the second pattern PA2 formed in the second exposure area AR2 based on the detection result of the detecting system 30 (light-receiving result of the light-receiving device 31) and the information stored in the storage device 6, without performing the measuring operation for measuring the position information about the image of the second pattern PA2 formed in the second exposure area AR2 (measuring operation using the spatial image-measuring device 162).

Subsequently, the controller 5 moves the substrate stage 4 in the XY direction to arrange the reference mark FP on the substrate stage 4 in the detecting area of the alignment system 7. The controller 5 detects the reference mark FP on the substrate stage 4 by using the alignment system 7 while measuring the position information about the substrate stage 4 by using the measuring system 3 (Step SA5). Accordingly, the controller 5 can determine the positional relationship between the detection reference position of the alignment system 7 and the reference mark FP in the XY coordinate system defined by the measuring system 3.

Subsequently, the controller 5 derives the positional relationship between the detection reference position of the alignment system 7 and the projection position of the image of the first pattern PA1 (Step SA6). The reference transmitting portion FM' on the reference plate 50 and the reference mark FP are formed in the predetermined positional relationship. The positional relationship between the reference transmitting portion FM' and the reference mark FP is known. The controller 5 can derive the positional relationship between the projection position of the image of the first pattern PA1 of the first mask M1 and the detection reference position of the alignment system 7 in the XY coordinate system defined by the measuring system 3 based on the positional relationship between the projection position of the image of the first pattern PA1 and the reference transmitting portion FM' determined in Step SA1, the positional relationship between the detection reference position of the alignment system 7 and the reference mark FP determined in Step SA6, and the known positional relationship between the reference transmitting portion FM' and the reference mark FP. That is, the controller 5 can determine the baseline amount of the alignment system 7 based on the projection position of the image of the first pattern PA1 determined in Step SA1, the detection reference position of the alignment system 7 determined in Step SA6, and the positional relationship between the reference transmitting portion FM' and the reference mark FP. In this embodiment, the projection position of the image of the first pattern PA1, which is determined in Step SA1, is used. However, the baseline amount may be determined by using the projection position of the image of the second pattern PA2 determined in Step SA3 instead of, or in combination with, the projection position of the image of the first pattern PA1.

The measurement may be performed by the spatial image-measuring device 162 after the reference mark FP is detected by the alignment system 7.

Subsequently, the controller 5 starts the alignment process for the substrate P on the substrate stage 4. The controller 5 moves the substrate stage 4 in the XY direction to successively arrange at least a part of the plurality of alignment marks AM provided corresponding to the shot areas S1 to S21 respectively on the substrate P, in the detecting area of the alignment system 7. The controller 5 successively detects the plurality of alignment marks AM on the substrate P by using the alignment system 7 while measuring the position information about the substrate stage 4 by using the measuring system 3 (Step SA7). Accordingly, the controller 5 can determine the positional relationship between the alignment mark AM and the detection reference position of the alignment system 7 in the XY coordinate system defined by the measuring system 3.

Subsequently, the controller 5 determines the respective pieces of position information about the plurality of shot areas S1 to S21 on the substrate P with respect to the detection reference position of the alignment system 7 by the calculation process based on the position information about the respective alignment marks AM on the substrate P determined in Step SA7 (Step SA8). Upon determining the respective pieces of position information about the plurality of shot areas S1 to S21 on the substrate P by the calculation process, it is possible to perform the determination by using the so-called EGA (enhanced global alignment) system as disclosed, for example, in Japanese Patent Application Laid-open No. 61-44429 (corresponding to United States Patent No. 4,780,617). With this, the controller 5 can detect the alignment marks AM on the substrate P by the alignment system 7 to determine the respective position coordinates (arrangement coordinates) of the plurality of shot areas S1 to S21 provided on the substrate P in the XY coordinate system defined by the measuring system 3. That is, the controller 5 can know where each of the shot areas S1 to S21 on the substrate P is positioned with respect to the detection reference position of the alignment system 7 in the XY coordinate system defined by the measuring system 3.

The controller 5 derives the positional relationship between the shot areas S1 to S21 on the substrate P and the projection position of the first pattern PA1 of the first mask M1 in the XY coordinate system based on the positional relationship between the detection reference position of the alignment system 7 and the shot areas S1 to S21 on the substrate P in the XY coordinate system determined in Step SA8 (arrangement information of the shot areas with respect to the detection reference position) and the positional relationship between the detection reference position of the alignment system 7 and the projection position of the image of the first pattern PA1 of the first mask M1 in the XY coordinate system determined in Step SA6 (baseline amount described above). That is, the controller 5 determines the position (coordinate value) in the XY coordinate system at which the exposure is correctly performed with the image of the first pattern PA1 for each of the shot areas on the substrate P. In this embodiment, the projection position of the first pattern PA1 is same as that of the second pattern PA2. Therefore, by moving the substrate P based on the determined position, it is possible to form the image of the first pattern PA1 and the image of the second pattern PA2 in the desired positional relationship in each of the shot areas on the substrate P.

Subsequently, the controller 5 starts the exposure for the shot area S on the substrate P (Step SA9). The controller 5 multiple-exposes the shot area S on the substrate P while moving the first pattern PA1 and the second pattern PA2 in the scanning directions (in the Y axis direction and the Z axis direction) respectively and moving the substrate P in the scanning direction (in the Y axis direction). Specifically, the controller 5 moves the first and second mask stages 1, 2 so that the first and second patterns are projected onto the exposure areas AR1, AR2 respectively at the desired timing, based on the results of Steps SA1, SA3, SA5 to SA8 described above, and the controller 5 moves the substrate stage 4 so that the patterns are formed at the desired position in each of the shot areas on the substrate P. The controller 5 illuminates the first pattern PA1 of the first mask M1 and the second pattern PA2 of the second mask M2 respectively with the first exposure light EL1 and the second exposure light EL2 so that the first exposure light EL1 and the second exposure light EL2 are irradiated onto the first exposure area AR1 and the second exposure area AR2 respectively on the substrate P to multiple-expose the shot area S on the substrate P, while synchronously performing the movement of the first mask M1 and the second mask M2 in the respective scanning directions (in the Y axis direction and the Z axis direction) by the first mask stage 1 and the second mask stage 2 and the movement of the substrate P in the scanning direction (in the Y axis direction) by the substrate stage 4, while detecting the position information about the first and second mask stages 1, 2 and the substrate stage 4 by using the measuring system 3.

The controller 5 radiates the first exposure light EL1 and the second exposure light EL2 onto the first exposure area AR1 and the second exposure area AR2 respectively to multiple-expose the shot area S on the substrate P, while synchronously performing the movement of the substrate P in the Y axis direction with respect to the first and second exposure areas AR1, AR2, the movement of the first mask M1 in the Y axis direction with respect to the first illumination area IA1, and the movement of the second mask M2 in the Z axis direction with respect to the second illumination area IA2. In this embodiment, for example, in a case that the first mask M1 is moved in the +Y direction during the exposure for the substrate P, the second mask M2 is moved in the +Z direction, and the substrate P is moved in the +Y direction.

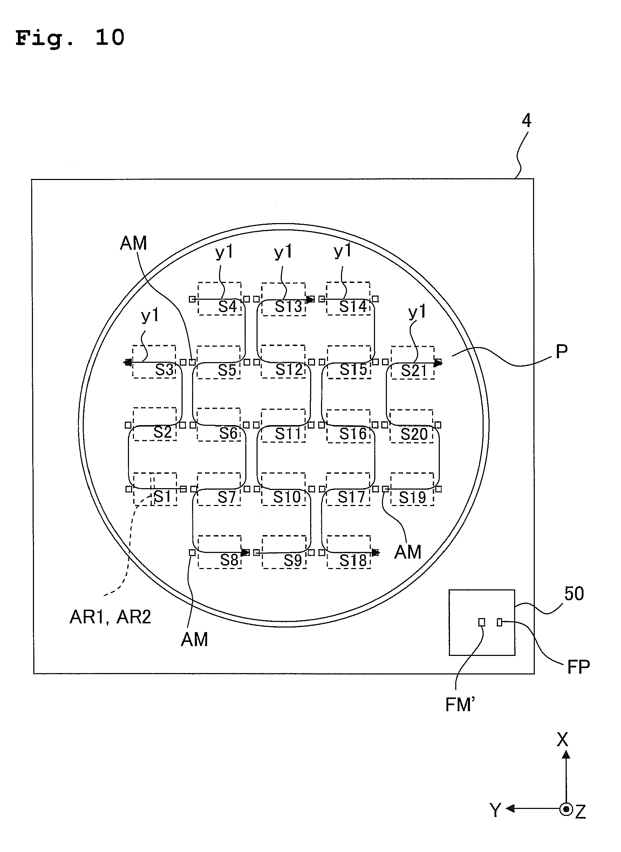

Fig. 10 is a plan view of the substrate stage 4 holding the substrate P. As shown in Fig. 10, the plurality of shot areas S1 to S21, which are the exposure objective areas, are defined in a matrix form on the substrate P. Further, the plurality of alignment marks AM are provided corresponding to the shot areas S1 to S21 respectively. When the shot areas S1 to S21 of the substrate P are exposed respectively, the controller 5 radiates the first and second exposure lights EL1, EL2 onto the substrate P by radiating the first and second exposure lights EL1, EL2 onto the first and second exposure areas AR1, AR2 while moving the first and second exposure areas AR1, AR2 relative to the substrate P, for example, as shown by the arrow y1 in Fig. 10. The controller 5 controls the operation of the substrate stage 4 so that the first and second exposure areas AR1, AR2 are moved along the arrow y1 with respect to the substrate P. The controller 5 successively multiple-exposes the plurality of shot areas S1 to S21 on the substrate P by repeating the scanning operation of the substrate P in the -Y direction and the scanning operation of the substrate P in the +Y direction.

In this embodiment, one shot area S on the substrate P can be multiple-exposed (double-exposed) with the image of the first pattern PA1 and the image of the second pattern PA2 by one time of the scanning operation. The photosensitive material layer of the shot area S on the substrate P is multiple-exposed (double-exposed) with the first exposure light EL1 radiated onto the first exposure area AR1 and the second exposure light EL2 radiated onto the second exposure area AR2 without performing the developing step, etc.

In this embodiment, the controller 5 concurrently (or simultaneously) performs the operation for multiple-exposing the shot area S on the substrate P with the image of the first pattern PA1 and the image of the second pattern PA2 and the detecting operation by the detecting system 30. That is, in this embodiment, the detecting system 30 detects the positional relationship between the edge image of the transmitting portion 36 and the images of the first and second alignment marks RM1, RM2 formed on the light-receiving surface 32a of the light-receiving device 31 concurrently with at least a part of the operation to multiple-expose the shot area S on the substrate P with the image of the first pattern PA1 and the image of the second pattern PA2 (for example, while synchronously moving the first mask M1, the second mask M2, and the substrate P). That is, the controller 5 successively detects the image of the alignment mark successively formed on the light-receiving surface 32a of the light-receiving element 32 by using the detecting system 30 concurrently with at least a part of the operation to multiple-expose the shot area S on the substrate P to obtain the information about the positional relationship among the image of the first pattern PA1, the image of the second pattern PA2, and the substrate P via at least a part of the projection optical system PL.

The controller 5 adjusts at least one of the positions of the first pattern PA1 and the second pattern PA2 based on the output of the light-receiving device 31 of the detecting system 30 during the exposure of the substrate P. That is, the controller 5 adjusts at least one of the position of the image of the first pattern PA1 formed in the first exposure area AR1 (i.e., the positional relationship between the image of the first pattern PA1 and the shot area S of the substrate P), the position of the image of the second pattern PA2 formed in the second exposure area AR2 (i.e., the positional relationship between the image of the second pattern PA2 and the shot area S of the substrate P), and the positional relationship between the image of the first pattern PA1 and the image of the second pattern PA2, based on the output of the light-receiving device 31 of the detecting system 30, so that the respective patterns are formed at the desired position in each of the shot areas on the substrate P.

When the first mask M1 and the second mask M2 are moved in the respective scanning directions (in the Y axis direction and the Z axis direction) in order to multiple-expose the shot area S on the substrate P, the first alignment mark RM1 is moved in the scanning direction (Y axis direction) of the first mask M1 together with the first pattern PA1, and the second alignment mark RM2 is moved in the scanning direction (Z axis direction) of the second mask M2 together with the second pattern PA2. However, as described above, the first alignment mark RM1 is arranged inside the first illumination area IA1, and the second alignment mark RM2 is arranged inside the second illumination area IA2. Therefore, even during the exposure of the substrate P, the first alignment mark RM1 arranged in the first illumination area IA1 is illuminated with the first exposure light EL1, and the second alignment mark RM2 arranged in the second illumination area IA2 is illuminated with the second exposure light EL2. Therefore, the image of the first alignment mark RM1 arranged in the first illumination area IA1 and the image of the second alignment mark RM2 arranged in the second illumination area IA2 are formed on the light-receiving surface 32a of the light-receiving device 31 of the detecting system 30 even during the exposure of the substrate P.

As shown in Fig. 2, the plurality of first alignment marks RM1 are formed and aligned in the scanning direction (Y axis direction) on the first mask M1, and the plurality of second alignment marks RM2 are formed and aligned in the scanning direction (Z axis direction) on the second mask M2. Therefore, when the first mask M1 and the second mask M2 are moved in the respective scanning directions (in the Y axis direction and the Z axis direction) in order to multiple-expose the shot area S on the substrate P, then the plurality of first alignment marks RM1 are successively arranged in the first illumination area IA1, and the plurality of second alignment marks RM2 are successively arranged in the second illumination area IA2.

The detecting system 30 successively obtains the position information about the image of the first alignment mark RM1 formed on the light-receiving surface 32a and the position information about the image of the second alignment mark RM2 formed on the light-receiving surface 32a, when the first mask M1 and the second mask M2 are moved in the respective scanning directions (in the Y axis direction and the Z axis direction) in order to multiple-expose the shot area S on the substrate P.

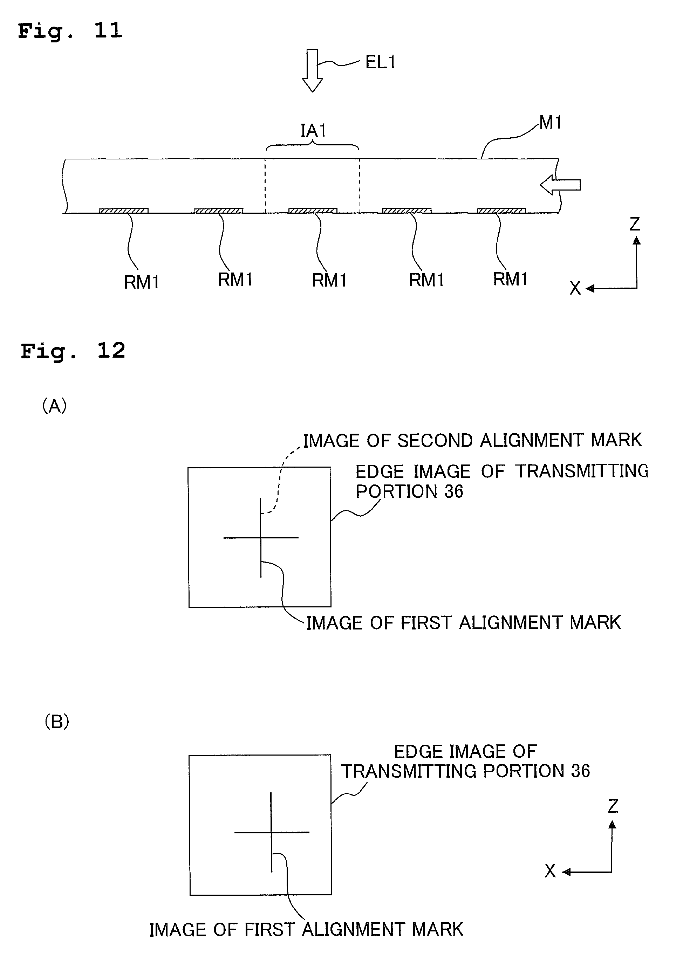

For example, a consideration is made in relation to such a situation that a certain first alignment mark RM1, which is included in the plurality of first alignment marks RM1 on the first mask M1, is illuminated with the first exposure light EL1 as schematically shown in Fig. 11 at a first timing during the exposure of the shot area S on the substrate P. When the first pattern PA1 (partial image of the first pattern PA1) is arranged at the target position at the first timing, it is assumed that the image of the certain first alignment mark RM1 is formed at a predetermined position on the light-receiving surface 32a as schematically shown in Fig. 12(A) (it is assumed that the image of the first alignment mark RM1 is formed approximately at the center of the rectangular edge image of the transmitting portion 36 in this case). Similarly, when the second pattern PA2 (partial image of the second pattern PA2) is arranged at the target position at the first timing, it is assumed that the image of the certain second alignment mark RM2 is formed at the predetermined position on the light-receiving surface 32a as shown in Fig. 12(A) (it is assumed that the image of the second alignment mark RM2 is formed approximately at the center of the rectangular edge image of the transmitting portion 36 in this case).

When the first pattern PA1 (partial image of the first pattern PA1) is deviated or shifted from the target position at the first timing (for example, when the first pattern PA1 is deviated in the X axis direction from the target position), the certain first alignment mark RM1 is also arranged at any position deviated from the state shown in Fig. 11. In this case, as schematically shown in Fig. 12(B), the image of the first alignment mark RM1 at the first timing is formed at any position deviated in the X axis direction from the state shown in Fig. 12(A). Similarly, when the second pattern PA2 (partial image of the second pattern PA2) is deviated from the target position at the first timing, the image of the certain second alignment mark RM2 at the first timing is also formed at any deviated position.

Therefore, the controller 5 can obtain at least one of the position information about the image of the first pattern PA1 formed in the first exposure area AR1, the position information about the image of the second pattern PA2 formed in the second exposure area AR2, the position information about the first pattern PA1, the position information about the second pattern PA2, the positional relationship between the image (partial image) of the first pattern PA1 and the image (partial image) of the second pattern PA2, and the positional relationship between the first pattern PA1 and the second pattern PA2, based on at least one of the position information about the image of the first alignment mark RM1 formed on the light-receiving surface 32a of the light-receiving device 31 of the detecting system 30 (positional relationship between the image of the first alignment mark RM1 and the edge image of the transmitting portion 36) and the position information about the second alignment mark RM2 (positional relationship between the image of the second alignment mark RM2 and the edge image of the transmitting portion 36).

The controller 5 multiple-exposes the shot area S on the substrate P while adjusting the positions of the first mask stage 1 and the second mask stage 2 based on the output of the light-receiving device 31 so that the image of the first pattern PA1, the image of the second pattern PA2, and the shot area S on the substrate P are in the desired positional relationship during the multiple exposure for the shot area S on the substrate P.

As described above, when one shot area S on the substrate P is multiple-exposed, there is such a possibility that the positional relationship among the first pattern PA1 of the first mask M1, the second pattern PA2 of the second mask M2, and the shot area S on the substrate P might be deviated or shifted from the target positional relationship. However, in this embodiment, when one shot area S on the substrate P is multiple-exposed, the detecting system 30 is used to detect the positional relationship among the first pattern PA1, the second pattern PA2, and the shot area S on the substrate P as well as the positional relationship among the image of the first pattern PA1, the image of the second pattern PA2, and the shot area S on the substrate P. Therefore, the controller 5 can multiple-expose the shot area S on the substrate P while adjusting the positional relationship among the image of the first pattern PA1, the image of the second pattern PA2, and the shot area S on the substrate P based on the information obtained by the detecting system 30. For example, if it is judged that the positional relationship between the first pattern PA1 of the first mask M1 and the second pattern PA2 of the second mask M2 is deviated from the target positional relationship based on the information obtained by the detecting system 30 during the multiple exposure for one shot area S on the substrate P, then the controller 5 adjusts at least one of the positions of the first mask stage 1 and the second mask stage 2 to adjust at least one of the positions of the first pattern PA1 of the first mask M1 and the second pattern PA2 of the second mask M2 based on the detection result of the detecting system 30 during the multiple exposure for the one shot area S of the substrate P. Accordingly, the positional relationship among the first pattern PA1 of the first mask M1, the second pattern PA2 of the second mask M2, and the shot area S on the substrate P is always adjusted to be in the desired state, thereby making it possible to form the image of the first pattern PA1 and the image of the second pattern PA2 at the desired position in the shot area S on the substrate P. The positions of the images of the first and second patterns PA1, PA2 may be adjusted by using at least one of the first and second image formation characteristic-adjusting devices LC1, LC2 in place of or in addition to the positional adjustment for the first mask stage 1 and the second mask stage 2 based on the detection result of the detecting system 30.

In the foregoing description, the position information about the images of the first and second patterns PA1, PA2 formed in the exposure areas (AR1, AR2) and/or the position information about the first and second patterns PA1, PA2 is/are obtained based on the positional relationship between the edge image of the transmitting portion 36 and the image of the first alignment mark RM1 formed on the light-receiving surface 32a of the light-receiving device 31 and/or the positional relationship between the edge image of the transmitting portion 36 and the image of the second alignment mark RM2. However, the alignment marks RM1, RM2 are also moved in the Y axis direction with respect to the exposure lights (EL1, EL2) in accordance with the movement of the masks M1, M2 during the exposure of the substrate P. Therefore, the images of the alignment marks RM1, RM2 are also moved on the light-receiving surface 32a of the light-receiving element 32. Therefore, upon detecting the positional deviations in the Y axis direction for the first and second alignment marks RM1, RM2, it is appropriate to determine the positional relationship between the image of the first alignment mark RM1 and the edge image of the transmitting portion 36 and/or the positional relationship between the image of the second alignment mark RM2 and the edge image of the transmitting portion 36 at the predetermined timing at which the images of the first and second alignment marks RM1, RM2 are to be formed at the predetermined positions (for example, at the center of the rectangular edge image) with respect to the edge image of the transmitting portion 36.

In the foregoing description, the position information about the image of the first pattern PA1 formed in the first exposure area AR1 and the position information about the image of the second pattern PA2 formed in the second exposure area AR2 are obtained by using the spatial image-measuring device 162 provided for the substrate stage 4. However, the information as described above may be obtained by any other method. For example, the first and second alignment marks RM1, RM2 and the transmitting portion FM' of the reference plate 50 (or any other reference mark) may be detected to obtain the position information about the images of the first and second patterns PA1, PA2 by using alignment systems arranged over or above the first and second masks M1, M2 respectively.

As explained above, the first exposure light EL1 and the second exposure light EL2 are radiated onto the first exposure area AR1 and the second exposure area AR2 respectively, and the substrate P is moved in the Y axis direction so that the shot area S on the substrate P is allowed to pass across the first exposure area AR1 and the second exposure area AR2. Accordingly, it is possible to efficiently multiple-expose the shot area S of the substrate P. In this embodiment, when the shot area S on the substrate P is multiple-exposed (double-exposed), one shot area S can be exposed with the image of the first pattern PA1 and the image of the second pattern PA2 by one time of the scanning operation wherein it is possible to improve the throughput. The plurality of shot areas S on the substrate P can be efficiently multiple-exposed by repeating the scanning operation in the -Y direction and the scanning operation in the +Y direction for the substrate P. The image of the first pattern PA1 and the image of the second pattern PA2 can be formed in the desired positional relationship in each of the shot areas S, because one shot area S can be multiple-exposed by one time of the scanning operation.

In this embodiment, it is possible to detect, by using the detecting system 30, the positional relationship among the image of the first pattern PA1, the image of the second pattern PA2, and the shot area S on the substrate P concurrently with the operation to multiple-expose the shot area S of the substrate P (while performing the multiple exposure). Therefore, the controller 5 can adjust the positional relationship among the image of the first pattern PA1, the image of the second pattern PA2, and the shot area S of the substrate P based on the information obtained by using the detecting system 30 even during the multiple exposure for the shot area S of the substrate P.

In this embodiment, the detecting system 30 receives, as the detection lights, the first and second exposure lights EL1 (S), EL2 (P) which do not travel to any one of the first exposure area AR1 and the second exposure area AR2 from the optical element 20, by the light-receiving device 30. Therefore, the image of the first pattern PA1 and the image of the second pattern PA2 can be formed at the desired position in the shot area S on the substrate P based on the information obtained by using the detecting system 30.

### Second Embodiment

Next, a second embodiment will be explained. In the following description, the constitutive parts or components, which are the same as or equivalent to those of the embodiment described above, are designated by the same reference numerals, any explanation of which will be simplified or omitted.

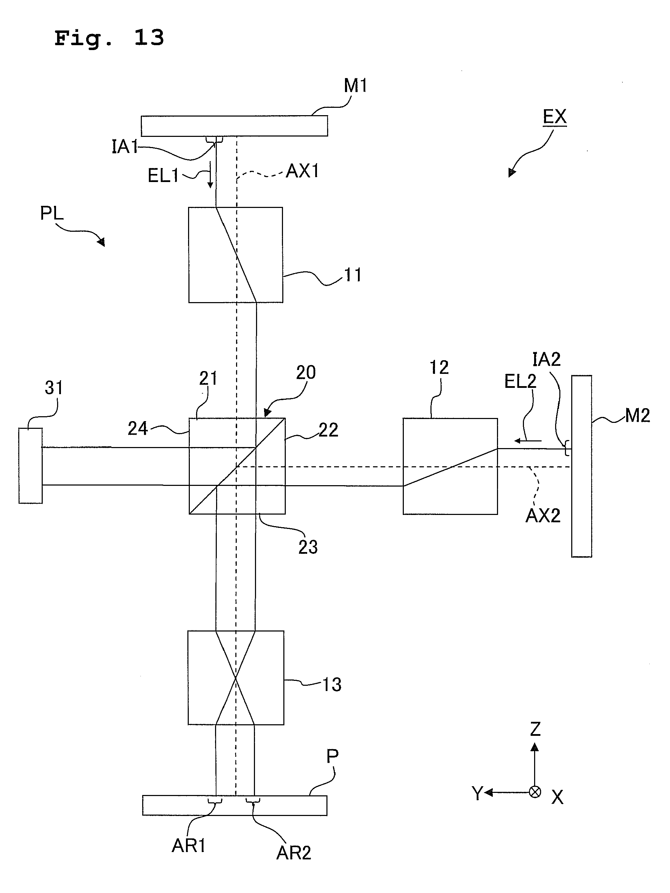

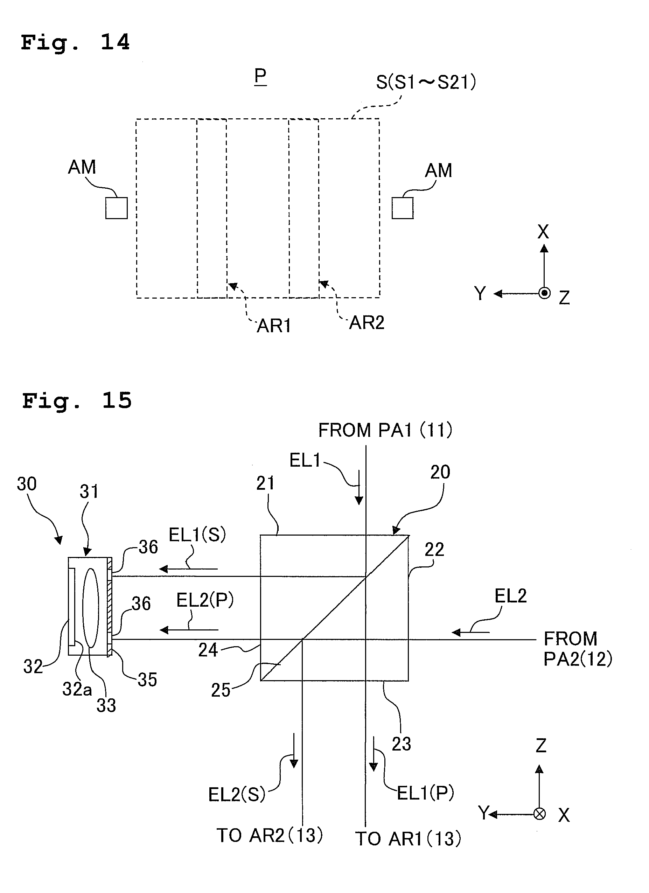

Fig. 13 shows a schematic construction illustrating an exposure apparatus EX according to the second embodiment. Fig. 14 schematically shows the positional relationship between the shot area S on the substrate P and the first and second exposure areas AR1, AR2 according to the second embodiment. As shown in Fig. 13, in the exposure apparatus EX of this embodiment, the first illumination area IA1 on the first mask M1 and the optical axis AX1 of the first optical system 11 are deviated or shifted from each other in the Y axis direction, and the second illumination area IA2 on the second mask M2 and the optical axis AX2 of the second optical system 12 are deviated from each other in the Z axis direction. In this case, as shown in Fig. 14, the first exposure area AR1 and the second exposure area AR2 are defined at different positions in the field of the projection optical system PL. Specifically, the first exposure area AR1 and the second exposure area AR2 are defined separately, for example, in relation to the Y axis direction (scanning direction for the substrate P). In this embodiment, the first exposure area AR1 and the second exposure area AR2 can be simultaneously arranged in one shot area S. That is, in this embodiment, the distance in the Y axis direction between the first exposure area AR1 (center of the first exposure area AR1) and the second exposure area AR2 (center of the second exposure area AR2) is smaller than the width in the Y axis direction of one shot area S on the substrate P.

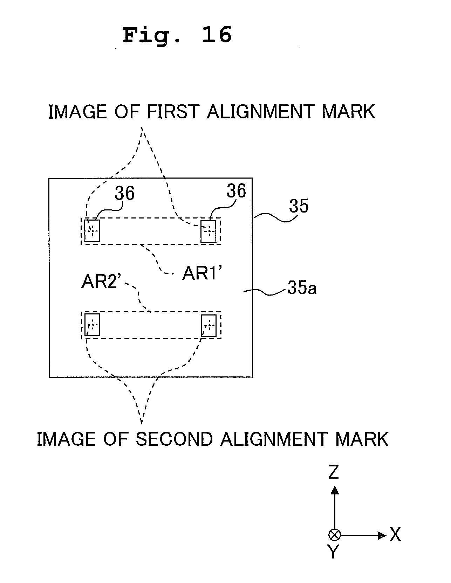

Fig. 15 shows an construction in the vicinity of a light-receiving device 31 according to the second embodiment. Fig. 16 shows an upper surface 35a of the plate member 35 of the light-receiving device 31. Also in this embodiment, the upper surface 35a of the plate member 35 of the light-receiving device 31 is arranged at a position which is optically conjugate with the object plane and the image plane of the projection optical system PL. Therefore, the first exposure light EL1 (S) and the second exposure light EL2 (P) come into the upper surface 35a of the plate member 35 of the light-receiving device 31 in a positional relationship same as that of the first exposure area AR1 and the second exposure area AR2 which are defined on the image plane side of the projection optical system PL. As shown in Fig. 14, in this embodiment, the projection optical system PL defines the first exposure area AR1 and the second exposure area AR2 on the substrate P so that the first exposure area AR1 and the second exposure area AR2 are separated from each other in the Y axis direction. Therefore, the first exposure light EL1 (S) and the second exposure light EL2 (P) come, on the upper surface 35a of the plate member 35 of the light-receiving device 31 optically arranged with respect to the surface of the substrate P, into the first detection light area AR1' and the second detection light area AR2' respectively formed separately in the Z axis direction respectively in the positional relationship which is the same as or equivalent to that of the first exposure area AR1 and the second exposure area AR2.

The image of the first pattern PA1 and the image of the first alignment mark RM1 can be formed in the first detection light area AR1' by radiating the first exposure light EL1 (S) onto the first detection light area AR1'. The image of the second pattern PA2 and the image of the second alignment mark RM2 can be formed in the second detection light area AR2' by radiating the second exposure light EL2 (P) onto the second detection light area AR2'.

As shown in Fig. 16, the transmitting portions 36 of the light-receiving device 31 are arranged at the positions at which the image of the first alignment mark RM1 and the image of the second alignment mark RM2 can be formed on the upper surface 35a of the plate member 35. In this embodiment, the image of the first alignment mark RM1 and the image of the second alignment mark RM2 are formed separately in the Z axis direction. Therefore, the transmitting portions 36 are formed at four positions on the upper surface 35a of the plate member 35.

In the same manner as in the first embodiment described above, the detecting system 30 is capable of determining, based on the light-receiving result of the light-receiving device 31, the positional relationship between the edge image of the transmitting portion 36 and the image of the first alignment mark RM1 formed via the part of the projection optical system PL on the light-receiving surface 32a of the light-receiving device 31. Therefore, the controller 5 is capable of determining the position information about the image of the first pattern PA1 and/or the position information about the first pattern PA1 by determining the positional relationship between the image of the first alignment mark RM1 and the edge image of the transmitting portion 36. Similarly, the detecting system 30 is capable of determining, based on the light-receiving result of the light-receiving device 31, the positional relationship between the edge image of the transmitting portion 36 and the image of the second alignment mark RM2 formed via the part of the projection optical system PL on the light-receiving surface 32a of the light-receiving device 31. Therefore, the controller 5 is capable of determining the position information about the image of the second pattern PA2 and/or the position information about the second pattern PA2 by determining the positional relationship between the image of the second alignment mark RM2 and the edge image of the transmitting portion 36. The controller 5 is capable of obtaining the information about the positional relationship between the image of the first pattern PA1 and the image of the second pattern PA2 and/or the positional relationship between the first pattern PA1 and the second pattern PA2 based on the positional relationship between the image of the first alignment mark RM1 and the image of the second alignment mark RM2.

The controller 5 is capable of multiple-exposing the shot area S on the substrate P, while adjusting the positional relationship among the image of the first pattern PA1, the image of the second pattern PA2, and the shot area S on the substrate P based on the detection result of the detecting system 30.

As explained above, even when the first exposure area AR1 and the second exposure area AR2 are separated from each other, the controller 5 can obtain the information about the positional relationship among the image of the first pattern PA1, the image of the second pattern PA2, and the shot area S on the substrate P by using the detecting system 30. In this embodiment, the first and second exposure areas AR1, AR2 are arranged while being separated from each other in the Y axis direction on the substrate P. However, the first exposure area AR1 and the second exposure area AR2 may be arranged so that a part of the first exposure area AR1 and a part of the second exposure area AR2 are overlapped with each other.

In the first and second embodiments described above, the first alignment mark RM1 is illuminated with the first exposure light EL1 which is radiated from the first illumination system IL1 in order to illuminate the first pattern PA1 therewith, and the light-receiving device 31 receives the first exposure light EL1 from the first alignment mark RM1. However, for example, a first illumination device, which is capable of radiating a detection light having the same wavelength as that of the first exposure light EL1 and mainly composed of the S-polarized light component, may be provided distinctly from the first illumination system IL1. The first alignment mark RM1 may be illuminated with the detection light radiated from the first illumination device. Similarly, a second illumination device, which is capable of radiating a detection light having the same wavelength as that of the second exposure light EL2 and mainly composed of the P-polarized light component, may be provided distinctly from the second illumination system IL2. The second alignment mark RM2 may be illuminated with the detection light radiated from the second illumination device.

In the respective embodiments described above, both of the image of the first alignment mark RM1 and the image of the second alignment mark RM2 are detected by using the detecting system 30 during the multiple exposure for the substrate P. However, only any one of the image of the first alignment mark RM1 and the image of the second alignment mark RM2 may be detected to adjust the positional relationship among the image of the first pattern PA1, the image of the second pattern PA2, and the substrate P.

In the respective embodiments described above, the detecting operation of the detecting system 30 is performed concurrently with at least a part of the multiple exposure operation for the substrate P. However, it is also allowable that only the detecting operation is performed before starting the exposure for the substrate P. That is, the following procedure is also available. That is, the first and second masks M1, M2 are moved in the respective scanning directions with respect to the first and second exposure lights EL1, EL2 before starting the exposure for the substrate P, and the image of the first alignment mark RM1 and/or the image of the second alignment mark RM2 is/are detected by using the detecting system 30. The multiple exposure operation is performed for the shot area S on the substrate P while adjusting the positional relationship among the image of the first pattern PA1, the image of the second pattern PA2, and the substrate P based on the obtained result.

In the respective embodiments described above, the light-receiving device 31 obtains the position information about the first alignment mark RM1 and/or the second alignment mark RM2 with the edge of the transmitting portion 36, provided on the upper surface 35a of the plate member 35, as a reference. However a line sensor, etc. may be used as the light-receiving element 32, and the position information about the image of the first alignment mark RM1 and/or the image of the second alignment mark RM2 may be directly obtained from the output of the light-receiving element 32.

### Third Embodiment

Next, a third embodiment will be explained. In the following description, the constitutive parts or components, which are the same as or equivalent to those of the first embodiment, are designated by the same reference numerals, any explanation of which will be simplified or omitted.

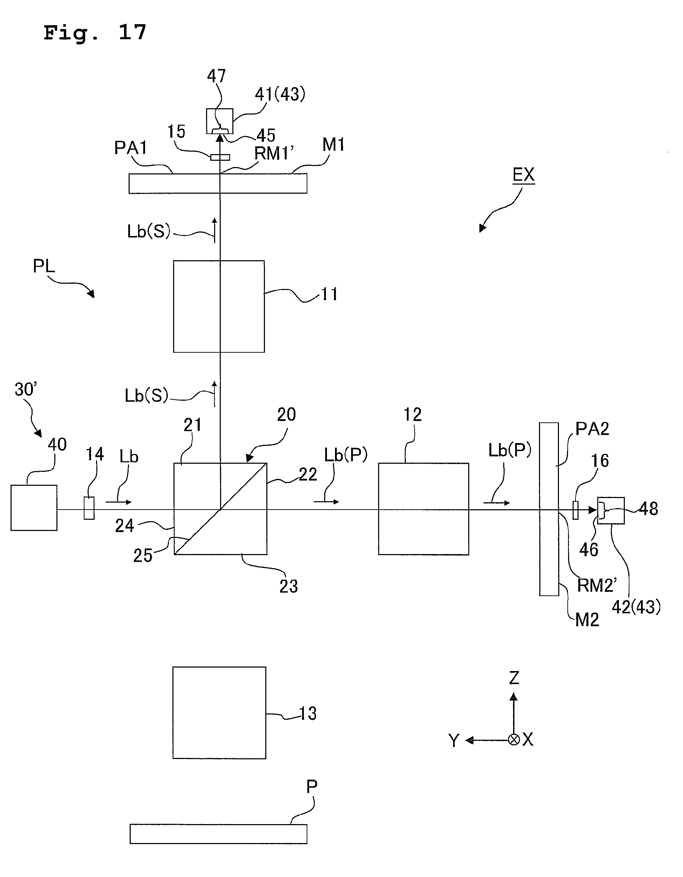

Fig. 17 shows a schematic construction of an exposure apparatus EX provided with a detecting system 30' according to the third embodiment. The detecting system 30' according to the third embodiment includes a radiating device 40 which radiates a detection light Lb that is distinct from the first and second exposure lights EL1, EL2, and a light-receiving device 43 which receives the detection light Lb from the radiating device 40 via at least a part of the projection optical system PL. The radiating device 40 radiates the detection light Lb having a wavelength which is different from those of the first and second exposure lights EL1, EL2. In this embodiment, the wavelengths of the first and second exposure lights EL1, EL2 are 193 nm, and the radiating device 40 radiates the detection light Lb which has a wavelength of, for example, about 633 nm. In this embodiment, the detection light Lb is a randomly polarized light (light beam).

A light beam, which has a wavelength same as those of the first and second exposure lights EL1, EL2, may be used as the detection light Lb. Alternatively, a light beam, which contains 50 % of P-polarized light component and 50 % of S-polarized light component, may be used as the detection light Lb.

The radiating device 40 radiates the detection light Lb toward an optical element 20 of the projection optical system PL. The light-receiving device 43 receives at least one of the detection light Lb from a first light-incident surface 21 of the optical element 20 and the detection light Lb from a second light-incident surface 22. As shown in Fig. 17, the light-receiving device 43 of this embodiment includes a first light-receiving device 41 which receives the detection light Lb from the first light-incident surface 21 of the optical element 20, and a second light-receiving device 42 which receives the detection light Lb from the second light-incident surface 22.

Specifically, the radiating device 40 radiates the detection light Lb onto a second light-exit surface 24 of the optical element 20. A part of the detection light Lb (S-polarized light component), coming into the second light-exit surface 24, exits from the first light-incident surface 21 of the optical element 20 via a predetermined plane (polarization splitting plane) 25. The remaining part of the detection light Lb (P-polarized light component), coming into the second light-exit surface 24, exits from the second light-incident surface 22 of the optical element 20 via a predetermined plane 25. In the following description, the detection light, which exits from the first light-incident surface 21, is appropriately referred to as "detection light Lb (S)", and the detection light, which exits from the second light-incident surface 22, is appropriately referred to as "detection light Lb (P)".

The detection light Lb (S), which exits from the first light-incident surface 21, is irradiated, via the first optical system 11, onto the first alignment mark RM1' formed in a predetermined positional relationship with respect to the first pattern PA1 of the first mask M1. The first light-receiving device 41 receives the detection light Lb (S) from the first alignment mark RM1'. That is, the first light-receiving device 41 receives the detection light Lb (S), radiated from the radiating device 40, via the predetermined plane 25 of the optical element 20, the first light-incident surface 21, and the first alignment mark RM1' formed in the predetermined positional relationship with respect to the first pattern PA1.

The detection light Lb (P), which exits from the second light-incident surface 22, is irradiated, via the second optical system 12, onto the second alignment mark RM2' formed in a predetermined positional relationship with respect to the second pattern PA2 of the second mask M2. The second light-receiving device 42 receives the detection light Lb (P) from the second alignment mark RM2'. That is, the second light-receiving device 42 receives the detection light Lb (P), radiated from the radiating device 40, via the predetermined plane 25 of the optical element 20, the second light-incident surface 22, and the second alignment mark RM2' formed in the predetermined positional relationship with respect to the second pattern PA2.

That is, the detection light Lb, which is radiated from the radiating device 40 and which comes into the optical element 20 via the second light-exit surface 24, does not travel or is not directed to any one of the first exposure area AR1 and the second exposure area AR2, and the detection light Lb travels in a direction different from those directed to the first exposure area AR1 and the second exposure area AR2, and is radiated onto the light-receiving device 43. The light-receiving device 43, which includes the first and second light-receiving devices 41, 42, receives the detection lights Lb from the optical element 20 which are not directed to any one of the first exposure area AR1 and the second exposure area AR2.

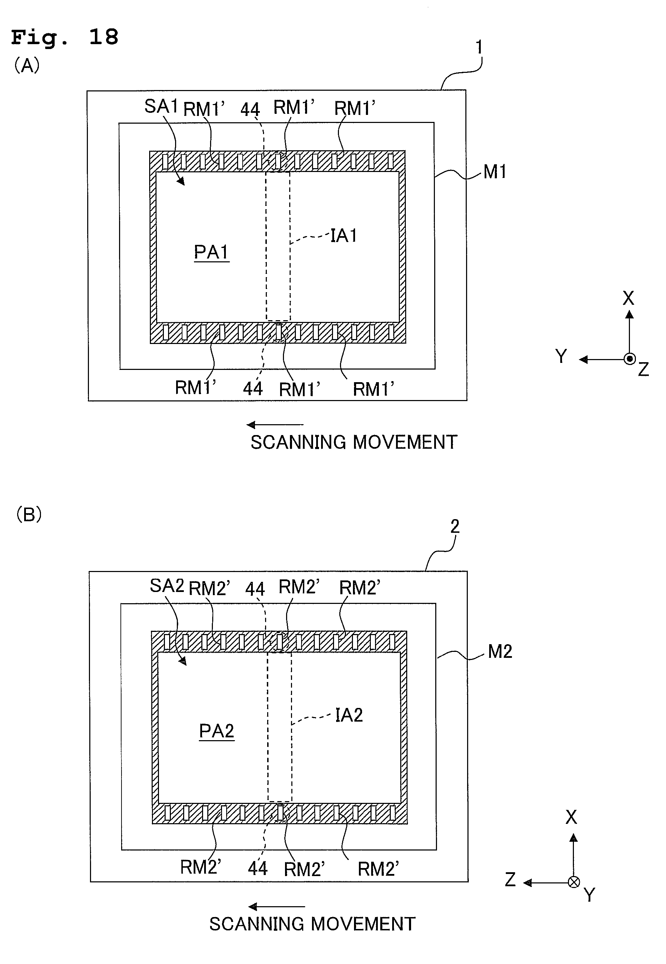

Fig. 18(A) is a plan view of the first mask M1 held by the first mask stage 1 according to this embodiment, and Fig. 18(B) is a plan view of the second mask M2 held by the second mask stage 2. Also in this embodiment, the first illumination area IA1, which is formed by the first exposure light EL1 on the first mask M1, is defined to have the rectangular (slit-shaped) form in which the X axis direction is the longitudinal direction. The second illumination area IA2, which is formed by the second exposure light EL2 on the second mask M2, is also defined to have the rectangular (slit-shaped) form in which the X axis direction is the longitudinal direction. Also in this embodiment, the first mask stage 1 is capable of moving the first mask M1 having the first pattern PA1 in the Y axis direction with respect to the first exposure light EL1, and the second mask stage 2 is capable of moving the second mask M2 having the second pattern PA2 in the Z axis direction with respect to the second exposure light EL2.

As shown in Fig. 18(A), in this embodiment, a plurality of the first alignment marks RM1' are formed and aligned in the scanning direction of the first mask M1 (Y axis direction), on the both sides of the first pattern formation area SA1 of the first mask M1 in relation to the X axis direction. In this embodiment, the first alignment marks RM1' are formed at the outside of the first pattern formation area SA1, and are arranged at the outside of the first illumination area IA1. Therefore, for example, when the substrate P is exposed, the first alignment marks RM1' are not illuminated with the first exposure light EL1 from the first illumination system IL1. Further, as shown in Fig. 18(B), a plurality of the second alignment marks RM2' are formed and aligned in the scanning direction of the second mask M2 (Z axis direction) on the both sides of the second pattern formation area SA2 of the second mask M2 in relation to the X axis direction. The second alignment marks RM2' are also formed at the outside of the second pattern formation area SA2, and are arranged at the outside of the second illumination area IA2. Therefore, for example, when the substrate P is exposed, the second alignment marks RM2' are not illuminated with the second exposure light EL2 from the second illumination system IL2. Also in this embodiment, the first alignment marks RM1' and the second alignment marks RM2' are formed on the first mask M1 and the second mask respectively so that the first alignment marks RM1' and the second alignment marks RM2' correspond to one another.

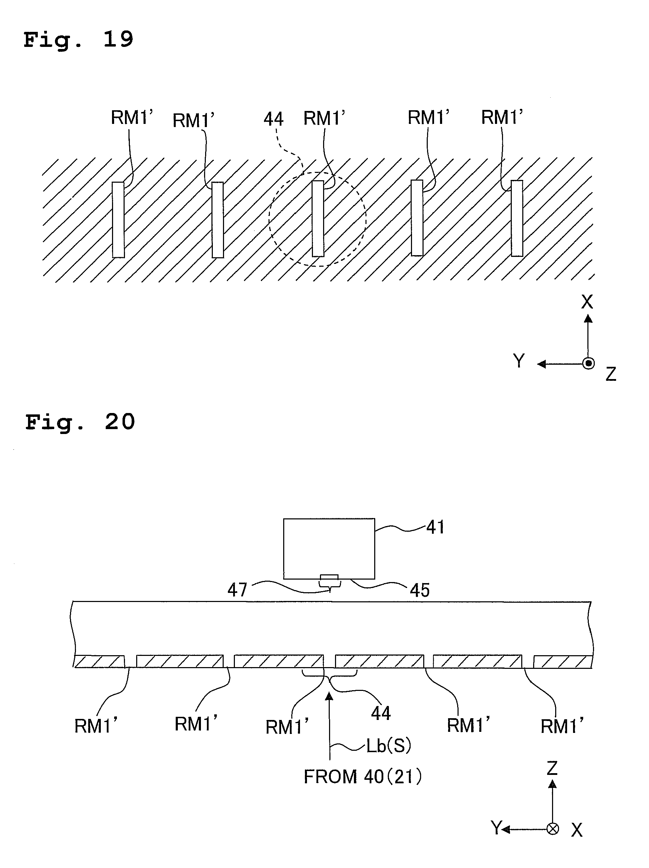

Fig. 19 is a magnified view of the first alignment marks RM1' according to this embodiment, and Fig. 20 schematically shows the relationship between the first light-receiving device 41 and the first mask M1. The first alignment mark RM1' is constructed of an aperture formed in a light-shielding area formed of, for example, a metal such as Cr (chromium) on the first mask M1, through which the detection light Lb (S) is transmissive. As shown in Fig. 19, the first alignment mark RM1' is the rectangular (slit-shaped) aperture (transmitting area) in which the longitudinal direction is the direction (X axis direction) that intersects the scanning direction of the first mask M1 (Y axis direction). The first alignment marks RM1' can be arranged in an irradiation area 44 which is irradiated with the detection light Lb (S) radiated from the radiating device 40. At least a part of the detection light Lb (S), which is emitted from the radiating device 40 and which is radiated onto the first alignment mark RM1' via the optical element 20 and the first optical system 11, passes through the first alignment mark RM1' arranged in the irradiation area 44 and arrives at a first light-receiving surface 45 of the first light-receiving device 41.

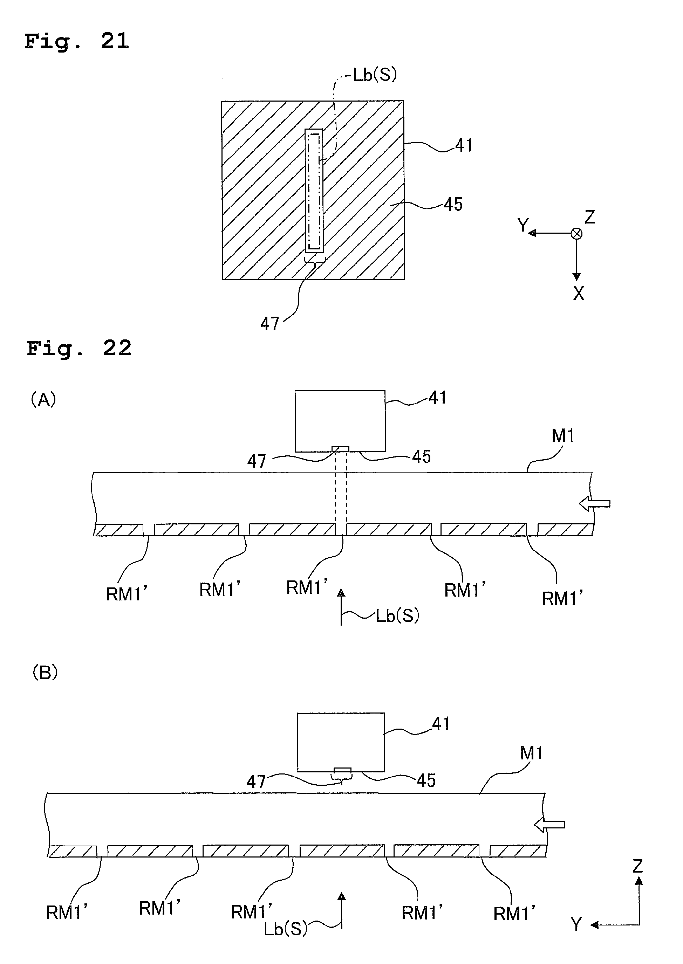

Fig. 21 schematically shows the first light-receiving surface 45 of the first light-receiving device 41. A light-receiving area 47, which is capable of receiving the detection light Lb (S), is formed on the first light-receiving surface 45. In this embodiment, the light-receiving area 47 is formed in a rectangular (slit-shaped) form in which the X axis direction is the longitudinal direction to correspond to the first alignment mark RM1'. When the first alignment mark RM1' is arranged in the irradiation area 44 of the detection light Lb (S), the detection light Lb (S), passing through the first alignment mark RM1', is radiated onto the light-receiving area 47 of the first light-receiving surface 45; and the first light-receiving device 41 receives the detection light Lb (S). Therefore, the detecting system 30' can detect whether or not the first alignment mark RM1' is arranged in the irradiation area 44, based on the output of the first light-receiving device 41.

The second alignment mark RM2' of the second mask M2 can be arranged in the irradiation area 44 formed by the detection light Lb (P) radiated from the radiating device 40, in the same manner as the first alignment mark RM1'. At least a part of the detection light Lb (P), emitted from the radiating device 40 and irradiated via the optical element 20 and the second optical system 12, is transmissive through the second alignment mark RM2'. The second alignment mark RM2' is a rectangular (slit-shaped) aperture in which the longitudinal direction is the direction (X axis direction) which intersects the scanning direction of the second mask M2 (Z axis direction). The detection light Lb (P), passing through the second alignment mark RM2', is irradiated onto the second light-receiving surface 46 of the second light-receiving device 42. A rectangular (slit-shaped) transmitting area 48, which has the longitudinal direction in the X axis direction, is formed on the second light-receiving surface 46 of the second light-receiving device 42 to correspond to the second alignment mark RM2' in the same manner as in the first light-receiving device 41. When the second alignment mark RM2' is arranged in the irradiation area 44 of the detection light Lb (P), the detection light Lb (P), passing through the second alignment mark RM2', is irradiated onto the transmitting area 48 of the second light-receiving surface 46; and the second light-receiving device 42 receives the detection light Lb (P). Therefore, the detecting system 30' can detect whether or not the second alignment mark RM2' is arranged in the irradiation area 44, based on the output of the second light-receiving device 42.

Each of the optical elements of the projection optical system PL is optimized with respect to the first and second exposure lights EL1, EL2. A correcting optical system 14 is provided between the radiating device 40 and the optical element 20. The correcting optical system corrects, for example, the chromatic aberration so that the detection light Lb comes into the light-receiving device 43 in a desired state. Further, an optical system 15 is provided between the first mask M1 and the first light-receiving device 41. The optical system 15 focuses the image of the first alignment mark RM1' illuminated with the detection light Lb (S) on the first light-receiving surface 45. Similarly, an optical system 16 is provided between the second mask M2 and the second light-receiving device 42. The optical system 16 focuses the image of the second alignment mark RM2' illuminated with the detection light Lb (P) on the second light-receiving surface 46.

Next, an explanation will be made about a method for exposing the substrate P by using the exposure apparatus EX according to this embodiment. In the same manner as in the embodiment described above, the controller 5 controls the first mask stage 1, the second mask stage 2, and the substrate stage 4 to multiple-expose the shot area S on the substrate P with the image of the first pattern PA1 and the image of the second pattern PA2, while moving the first mask M1 having the first pattern PA1 and the second mask M2 having the second pattern PA2 in the scanning directions (in the Y axis direction and the Z axis direction) respectively and moving the substrate P in the scanning direction (in the Y axis direction).

In this embodiment, the controller 5 continuously radiates the detection light Lb from the radiating device 40 of the detecting system 30' toward the optical element 20 during the exposure of the substrate P. That is, the controller 5 continuously performs the radiating operation for radiating the detection light Lb by the radiating device 40 during the exposure of the substrate P. Therefore, the predetermined portions of the first and second masks M1, M2 are continuously illuminated with the detection lights Lb exiting from the first and second light-incident surfaces 21, 22 respectively of the optical element 20 during the period in which the substrate P is exposed.

The controller 5 can obtain the information about at least one of the positional relationship between the image of the first pattern PA1 and the image of the second pattern PA2 and the positional relationship between the first pattern PA1 and the second pattern PA2 based on the detection light Lb (S) irradiated via the first alignment mark RM1' onto the first light-receiving surface 45 of the first light-receiving device 41 and the detection light Lb (P) irradiated via the second alignment mark RM2' onto the second light-receiving surface 46 of the second light-receiving device 42.

The controller 5 can determine the positional relationship (positional deviation or shift) between the first pattern PA1 and the second pattern PA2 and/or the positional relationship (positional deviation) between the image (partial image) of the first pattern PA1 and the image (partial image) of the second pattern PA2 projected onto the shot area S during the exposure of the shot area S on the substrate P, based on the timing at which the detection light Lb (S) is irradiated via the first alignment mark RM1' onto the first light-receiving surface 45 of the first light-receiving device 41 of the detecting system 30' and the timing at which the detection light Lb (P) is irradiated via the second alignment mark RM2' corresponding to the first alignment mark RM1' onto the second light-receiving surface 46 of the second light-receiving device 42.

For example, a consideration is made in relation to a case in which a certain first alignment mark RM1' among the plurality of first alignment marks RM1' on the first mask M1 is arranged in the irradiation area 44 as schematically shown in Fig. 22(A) at a first timing during the exposure of the shot area S on the substrate P. When the first pattern PA1 (partial image of the first pattern PA1) is arranged at a target position at the first timing, it is assumed that the certain first alignment mark RM1' is arranged in the irradiation area 44. Similarly, when the second pattern PA2 (partial image of the second pattern PA2) is arranged at a target position at the first timing, it is assumed that the image of the certain second alignment mark RM2' is arranged in the irradiation area 44.

If the first pattern PA1 (partial image of the first pattern PA1) is deviated or shifted from the target position at the first timing, as schematically shown in Fig. 22(B), then the certain first alignment mark RM1' is also arranged at any position deviated from the irradiation area 44 at the first timing. That is, since the first alignment mark RM1' is not arranged in the irradiation area 44 at the first timing, the detection light Lb (S) is blocked or shielded by the light-shielding area, and thus the detection light Lb (S) does not arrive at the first light-receiving device 41. When the second pattern PA2 (partial image of the second pattern PA2) is arranged at the target position at the first timing, the certain second alignment mark RM2', which corresponds to the certain first alignment mark RM1', is also arranged in the irradiation area 44 at the first timing. That is, the corresponding first and second alignment marks RM1', RM2' are arranged in the irradiation area 44 at the different timings, and the first and second light-receiving devices 41, 42 receive the detection lights Lb at the different timings.

The controller 5 compares the timing at which the detection light Lb passed through the first alignment mark RM1' is received by the first light-receiving device 41, i.e., the timing at which the image of the first alignment mark RM1' is formed in the light-receiving area 47 on the first light-receiving surface 45 with the timing at which the detection light Lb passed through the second alignment mark RM2' is received by the second light-receiving device 42, i.e., the timing at which the image of the second alignment mark RM2' is formed in the light-receiving area 48 on the second light-receiving surface 46, thereby making it possible to obtain the positional relationship between the image of the first pattern PA1 and the image of the second pattern PA2 and/or the positional relationship between the first pattern PA1 and the second pattern PA2 based on the result of the comparison.

The controller 5 multiple-exposes the shot area S on the substrate P while adjusting the positions of the first mask stage 1 and the second mask stage 2 based on the output of the light-receiving device 43 so that the image of the first pattern PA1, the image of the second pattern PA2, and the shot area S on the substrate P are in the desired positional relationship during the multiple exposure of the shot area S on the substrate P.

As explained above, also in this embodiment, the positional relationship between the first pattern PA1 and the second pattern PA2 and/or the positional relationship between the image of the first pattern PA1 and the image of the second pattern PA2 is/are detected by using the detecting system 30' when each of the shot areas S on the substrate P is multiple-exposed. Therefore, the controller 5 can multiple-expose the shot area S on the substrate P while adjusting the positional relationship among the image of the first pattern PA1, the image of the second pattern PA2, and the shot area S on the substrate P based on the information obtained by the detecting system 30'.

In this embodiment, the detection light Lb, which has the wavelength different from those of the first and second exposure lights EL1, EL2, is used to detect the position information. Therefore, even when the detection light Lb, radiated from the radiating device 40, leaks onto the substrate P, it is possible to suppress any unnecessary exposure of the substrate P. In this embodiment, the first and second alignment marks RM1', RM2' are provided at the outside of the first and second illumination areas IA1, IA2, respectively, thereby making it possible to prevent the projection of the images of the first and second alignment marks RM1', RM2' from being projected onto the substrate P.

In this embodiment, each of the first and second alignment marks RM1', RM2' has such a shape that the longitudinal direction is the direction which intersects the scanning directions of the first and second masks M1, M2. The detecting system 30' can accurately detect the position information in relation to the respective scanning directions of the first and second patterns PA1, PA2 of the first and second masks M1, M2 based on the detection lights Lb via the first and second alignment marks RM1', RM2'.

Also in this embodiment, the detecting operation of the detecting system 30' may be executed before starting the multiple exposure for the shot area S on the substrate P. During the exposure of each of the shots disposed on the substrate P, it is possible to adjust, based on the result of the detection, a position of at least one of the first pattern PA1, the second pattern PA2, and the substrate P so that the image of the first pattern PA1, the image of the second pattern PA2, and the shot area S on the substrate P are in the desired positional relationship.

In the first to third embodiments described above, the adjustment is performed for at least one of the positions of the first mask M1 having the first pattern PA1 and the second mask M2 having the second pattern PA2 in order to adjust at least one of the positions of the image of the first pattern PA1 and the image of the second pattern PA2 formed in the exposure areas (AR1, AR2). However, the controller 5 is capable of performing the positional adjustment of at least one of the image of the first pattern PA1 formed in the first exposure area AR1 and the image of the second pattern PA2 formed in the second exposure area AR2 by using at least one of the first image formation characteristic-adjusting device LC1 and the second image formation characteristic-adjusting device LC2. As described above, the controller 5 is capable of performing the positional adjustment in the X axis direction, the Y axis direction, and the θZ direction of each of the images of the first and second patterns PA1, PA2 by using the first and second image formation characteristic-adjusting devices LC1, LC2. Therefore, the controller 5 can adjust the positional relationship among the image of the first pattern PA1, the image of the second pattern PA2, and the substrate P by adjusting at least one of the positions of the image of the first pattern PA1 and the image of the second pattern PA2 by using the first and second image formation characteristic-adjusting devices LC1, LC2 based on the output of the light-receiving device 31, for example, during the exposure of the substrate P.

In the respective embodiments described above, the polarization splitting optical element (polarization beam splitter) is used as the optical element 20. However, a branching optical element (half mirror), which branches the optical path for each of the first exposure light EL1 and the second exposure light EL2, may be used as the optical element 20. The branching optical element can branch the radiation light beam even when the radiation light beam, which includes, for example, the exposure lights EL1, EL2 and the detection light Lb to be used, is the randomly polarized light beam. It is possible to enhance the degree of freedom of the polarization state of the radiation light beam.

In the respective embodiments described above, when the first mask M1 is moved in the +Y direction, the second mask M2 is moved in the +Z direction. However, when the first mask M1 is moved in the +Y direction, the second mask M2 may be moved in the -Z direction.

In the respective embodiments described above, the first mask M1 is moved in the Y axis direction during the exposure of the substrate P, and the second mask M2 is moved in the direction (Z axis direction) which intersects the direction (Y axis direction) of the movement of the first mask M1. However, the projection optical system PL may be constructed so that the first mask M1 and the second mask M2 are moved in a same direction (for example, in the Y axis direction). In this case, for example, the projection optical system may be of the two-headed type. The first and second masks M1, M2, which have the first and second pattern formation surfaces formed on the identical plane on the object plane side of the projection optical system, may be moved in a same scanning direction on the different mask stages respectively. Alternatively, the first and second masks M1, M2 may be placed on a same mask stage to move the first and second masks M1, M2 in the same scanning direction. In the latter case, for example, the following construction is preferred. That is, an actuator, which moves the first mask M1 relative to the second mask M2 on the mask stage, is provided so that the positional relationship between the images of the first and second patterns PA1, PA2 is adjustable. In the respective embodiments described above, the first and second patterns PA1, PA2 are formed on the different masks (M1, M2). However, the first and second patterns PA1, PA2 may be formed on one mask.

In the respective embodiments described above, the projection optical system PL is not limited to the reduction system, and may be any one of, for example, the 1x magnification system and the magnifying system. The foregoing respective embodiments have been explained as exemplified by the catadioptric system including the catoptric optical element and the dioptric optical element, as the projection optical system PL by way of example. However, the projection optical system PL may be the dioptric system including no catoptric optical element, or the catoptric system including no dioptric optical element. Further, the projection optical system PL is not limited to the catadioptric system of the two-headed type. For example, it is also allowable to adopt the catadioptric system of the so-called inline type wherein an optical system (catoptric or dioptric system), which has a plurality of reflecting surfaces and which forms an intermediate image at least once, is provided at a part thereof, and the system has a single optical axis as disclosed, for example, in International Publication No. 2004/107011 (corresponding to United States Patent Application Publication No. 2006/0121364). The projected image generated by the projection optical system PL may be any one of an inverted image and an erecting image.

In the respective embodiments described above, at least one of the size and the shape may be different between the first exposure area AR1 and the second exposure area AR2. For example, the width in the X axis direction and/or the width in the Y axis direction may be different between the first exposure area AR1 and the second exposure area AR2. When the width in the X axis direction differs, only a part of the shot area S is multiple-exposed (double-exposed) by one time of the scanning operation. The shape of each of the first and second exposure areas AR1, AR2 (and/or the first and second illumination areas IA1, IA2) is not limited to the rectangular shape, and may be any other shape including, for example, circular arc-shaped, trapezoidal, parallelogramic shapes, etc.

In the respective embodiments described above, the exposure lights EL1, EL2 are continuously radiated onto the first exposure area AR1 and the second exposure area AR2 respectively during the period in which the shot area S passes across the first exposure area AR1 and the second exposure area AR2. However, it is also allowable that the exposure light is radiated only during a part of the period in which the shot area S passes across at least one of the exposure areas. That is, it is also allowable that only a part of the shot area S is multiple-exposed (double-exposed).
In the respective embodiments described above, although the alignment system 7 is of the image processing system, there is no limitation to this. For example, it is also allowable to adopt any other system including, for example, a system in which a diffracted light beam or the like generated from a mark by being irradiated with a coherent beam is detected. In the respective embodiments described above, the position information about the images of the first and second patterns PA1, PA2 is measured by using the spatial image-measuring device 162. However, the measuring device for measuring the position information is not limited to the spatial image-measuring device, and may be any device. Further, in the respective embodiments described above, the first and second alignment marks RM1, RM2 are detected by the detecting system 30 during the movement of the first and second masks M1, M2. However, the first and second alignment marks RM1, RM2 may be detected in a state that the first and second masks M1, M2 are allowed to stand still. In the respective embodiments described above, the substrate is double-exposed with the first and second patterns PA1, PA2. However, it is also allowable to perform the multiple exposure in which three or more patterns are used.

In the respective embodiments described above, it is also appropriate to apply the liquid immersion method as disclosed, for example, in International Publication No. 99/49504 and Japanese Patent Application Laid-open No. 2004-289126 (corresponding to United States Patent Publication No. 2004/0165159). That is, a liquid immersion area of a liquid may be formed on the substrate P by using a liquid immersion system so that the first and second exposure areas AR1, AR2 are covered therewith, and the first and second exposure lights EL1, EL2 may be radiated onto the substrate P via or through the liquid. The liquid immersion system may include a supply member which has a supply port for supplying the liquid to the optical path and a recovery member which has a recovery port for recovering the liquid, the supply and recovery member being provided, for example, in the vicinity of the optical path for the exposure light between the substrate P and the terminal end (final) optical element of the projection optical system PL. It is not necessarily indispensable that a part or parts of the liquid immersion system (for example, the liquid supply member and/or the liquid recovery member) is/are provided on the exposure apparatus. For example, any equipment of a factory or the like in which the exposure apparatus is installed may be substitutively used. The structure of the liquid immersion system is not limited to the structure as described above. It is possible to use those described, for example, in European Patent Publication No. 1420298, International Publication Nos. 2004/055803 and 2004/057590, International Publication No. 2005/029559 (corresponding to United States Patent Publication No. 2006/0231206), International Publication No. 2004/086468 (corresponding to United States Patent Publication No. 2005/0280791), and Japanese Patent Application Laid-open No. 2004-289126 (corresponding to United States Patent No. 6,952,253). The contents of, for example, United States Patent Publication No. 2006/0231206, United States Patent Publication No. 2005/0280791 and United States Patent No. 6,952,253, etc. described above are incorporated herein by reference within a range of permission of the domestic laws and ordinances of the designated state or the selected state in relation to the liquid immersion mechanism of the liquid immersion exposure apparatus and any apparatus equipped thereto.

As for the liquid to be used for the liquid immersion method, it is also allowable to use water (pure or purified water). Alternatively, it is also allowable to use those other than water, for example, fluorine-based fluids such as fluorine-based oil and perfluoropolyether (PFPE), and cedar oil. As for the liquid, it is also allowable to use any liquid having the refractive index with respect to the exposure light higher than that of water, for example, those having the refractive index of about 1.6 to 1.8. The liquid LQ, which has the refractive index (for example, not less than 1.5) higher than that of pure water, includes, for example, predetermined liquids having the C-H bond or the O-H bond such as isopropanol having a refractive index of about 1.50 and glycerol (glycerin) having a refractive index of about 1.61; predetermined liquids (organic solvents) such as hexane, heptane, and decane; and decalin (decahydronaphthalene) having a refractive index of about 1.60. As for the liquid LQ, it is also allowable to use those obtained by mixing arbitrary two or more liquids of the foregoing liquids, and it is also allowable to use those obtained by adding (mixing) at least one of the foregoing liquids to (with) pure water. Further, as for the liquid LQ, it is also allowable to use those obtained by adding (mixing) base or acid such as H⁺, Cs⁺, K⁺, Cl⁻, SO₄²⁻, and PO₄²⁻ to (with) pure water, and it is also allowable to use those obtained by adding (mixing) fine particles of Al oxide or the like to (with) pure water. As for the liquid LQ, it is preferable to use those which have a small coefficient of light absorption, which have a small temperature dependency, and which are stable against the photosensitive material (or, for example, the top coat film or the antireflection film) coated on the surface of the substrate P and/or the projection system PL. As for the liquid LQ, it is also possible to use the supercritical fluid. As for the substrate P, it is possible to provide, for example, the top coat film which protects the photosensitive material and the base material from the liquid. On the other hand, the final optical element FL may be formed of, for example, silica glass (silica) or any single crystal material of any fluorine compound such as calcium fluoride, barium fluoride, strontium fluoride, lithium fluoride, and sodium fluoride. Alternatively, the final optical element FL may be formed of any material having a refractive index (for example, not less than 1.6) higher than those of silica glass and calcium fluoride. Those usable as the material having the refractive index of not less than 1.6 include, for example, sapphire and germanium dioxide as disclosed, for example, in International Publication No. 2005/059617, and potassium chloride (refractive index: about 1.75) as disclosed in International Publication No. 2005/059618.

When the present invention is used for the liquid immersion method, it is also appropriate that the optical path on the object plane side of the final optical element is also filled with the liquid, in addition to the optical path on the image plane side of the final optical element as disclosed, for example, in International Publication No. 2004/019128 (corresponding to United States Patent Publication No. 2005/0248856). Further, a thin film, which has the lyophilic or liquid-attractive property and/or the dissolution-preventive or anti-dissolution function, may be formed on a part (including at least a contact surface which makes contact with the liquid) or all of the surface of the final optical element. The silica glass has a high affinity for the liquid, for which any dissolution-preventive film is not required as well. However, it is preferable for calcium fluoride to form at least the dissolution-preventive film.

The substrate P, which is usable in the respective embodiments described above, is not limited only to the semiconductor wafer for producing the semiconductor device. Those applicable include, for example, a glass substrate for a display device, a ceramic wafer for a thin film magnetic head, a master plate (synthetic silica glass, silicon wafer) for a mask or a reticle to be used for the exposure apparatus, and a film member. Further, the shape of the substrate P is not limited only to the circular shape, and may be any other shape including, for example, rectangular shapes.

The present invention is also applicable to an exposure apparatus of a multi-stage type provided with a plurality of substrate stages as disclosed, for example, in Japanese Patent Application Laid-open No. 10-163099, Japanese Patent Application Laid-open No. 10-214783 (corresponding to United States Patent Nos. 6,341,007, 6,400,441, 6,549,269, and 6,590,634), and Published Japanese Translation of PCT International Publication for Patent Application No. 2000-505958 (corresponding to United States Patent No. 5,969,441). The contents of United States Patent Nos. 6,341,007, 6,400,441, 6,549,269, 6,590,634 and 5,969,441 described above are incorporated herein by reference within a range of permission of the domestic laws and ordinances of the designated state or the selected state in relation to the exposure apparatus of the multi-stage type.

Further, the present invention is also applicable to an exposure apparatus provided with a substrate stage which holds the substrate and a measuring stage which is provided with a measuring member (for example, a reference member having a reference mark and/or various photoelectric sensors formed therein) as disclosed, for example, in Japanese Patent Application Laid-open No. 11-135400 (corresponding to International Publication No. 1999/23692) and Japanese Patent Application Laid-open No. 2000-164504 (corresponding to United States Patent No. 6,897,963). In the case of the exposure apparatus provided with both of the substrate stage and the measuring stage, all or a part of the plurality of measuring members including the spatial image-measuring device 162 may be provided on the measuring stage.

In the respective embodiments described above, the first and second masks M1, M2 are used in order to form the first and second patterns. However, instead of the first and second masks M1, M2, it is possible to use an electronic mask for generating a variable pattern (also referred to as "variable shaped mask", "active mask", or "pattern generator"). As for the electronic mask, for example, it is possible to use DMD (Deformable Micro-mirror Device or Digital Micro-mirror Device) as a kind of the no light-emitting image display device (also referred to as "spatial light modulator (SLM)". DMD has a plurality of reflecting elements (micro-mirrors) which are driven based on a predetermined electronic data. The plurality of reflecting elements are arranged in a two-dimensional matrix form on a surface of DMA, and each of the elements is driven individually (is driven by element by element) to reflect and deflect the exposure light. The angle of the reflecting surface of each of the reflecting elements is adjusted. The operation of DMD may be controlled by the controller 30. The controller 30 drives each of the reflecting elements of DMD based on the electronic data (pattern information) corresponding to the first pattern and the second pattern to be formed on the substrate P, and the exposure light radiated by the illumination system IL is patterned by the reflecting elements. By using DMD, it is unnecessary to perform the exchange operation for the mask and the alignment operation for the mask on the mask stage when the pattern is changed, as compared with the case that the exposure is performed by using the mask (reticle) on which the pattern is formed. Therefore, it is possible to perform the multiple exposure more efficiently. In the exposure apparatus using the electronic mask, it is enough that the substrate is moved only in the X axis direction and the Y axis direction by the substrate stage without providing the mask stage. In order to adjust the relative positions of the images of the first and second patterns on the substrate, for example, it is also appropriate to adjust, by an actuator or the like, the relative positions of the two electronic masks for generating the first and second patterns respectively. However, the timing for generating the pattern may be adjusted for at least one of the two electronic masks, and/or the pattern generation position may be deviated or shifted in the electronic mask. The exposure apparatus using DMD is disclosed, for example, in Japanese Patent Application Laid-open Nos. 8-313842 and 2004-304135 and United States Patent No. 6,778,257. The contents of United States Patent No. 6,778,257 is incorporated herein by reference within a range of permission of the domestic laws and ordinances of the designated state or the selected state.

In the respective embodiments described above, although the interferometer system is used to measure the position information about the mask stage and the substrate stage, there is no limitation to this. For example, it is also allowable to use an encoder system which detects a scale (diffraction grating) provided, for example, on the upper surface of the substrate stage. In this case, it is preferable that a hybrid system including both of the interferometer system and the encoder system is provided, and the measurement result of the encoder system is calibrated (subjected to the calibration) by using the measurement result of the interferometer system. The position control of the substrate stage may be performed by switchingly using the interferometer system and the encoder system, or using both of the interferometer system and the encoder.

In the respective embodiments described above, the ArF excimer laser is used as the light source device for generating the ArF excimer laser light beam as the exposure light EL. However, it is also allowable to use a high harmonic wave-generating device which includes, for example, a solid laser light source such as a DFB semiconductor laser or a fiber laser, a light-amplifying section having a fiber amplifier or the like, and a wavelength-converting section and which outputs a pulse light beam having a wavelength of 193 nm as disclosed, for example, in International Publication No. 1999/46835 (corresponding to United States Patent No. 7,023,610). Further, in the embodiments described above, the first and second illumination areas and the first and second exposure areas are rectangular respectively. However, it is also allowable to adopt any other shape including, for example, circular arc-shaped, trapezoidal, parallelogramic, rhombic shapes, etc.

As for the type of the exposure apparatus EX, the present invention is not limited to the exposure apparatus for the semiconductor device production for exposing the substrate P with the semiconductor device pattern. The present invention is also widely applicable, for example, to an exposure apparatus for producing the liquid crystal display device or for producing the display as well as an exposure apparatus for producing, for example, the thin film magnetic head, the micromachine, MEMS, the DNA chip, the image pickup device (CCD), the reticle, or the mask.

As for various United States Patents and United States Patent Application Publications referred to in this specification, the contents thereof are incorporated herein by reference within a range of permission of the domestic laws and ordinances of the designated state or the selected state, in relation to those other than those having been specifically and explicitly incorporated herein by reference as well.

As described above, the exposure apparatus EX according to the embodiment of the present invention is produced by assembling the various subsystems including the respective constitutive elements as defined in claims so that the predetermined mechanical accuracy, electric accuracy and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness, etc. are managed.

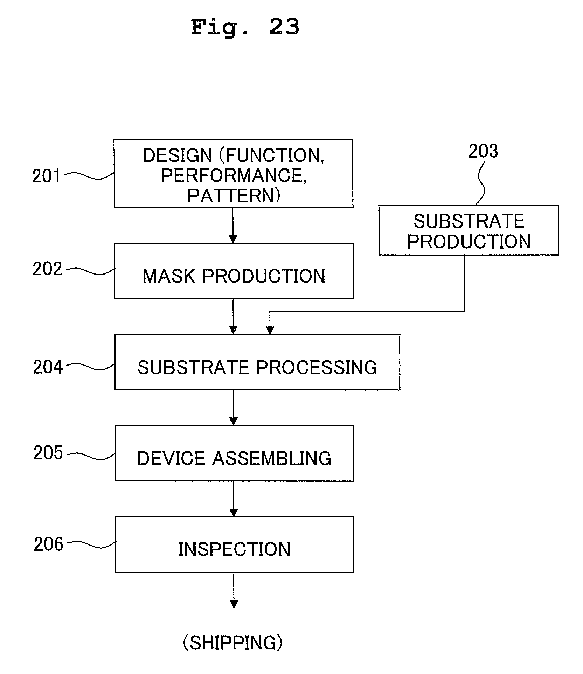

As shown in Fig. 23, the microdevice such as the semiconductor device is produced by performing, for example, a step 201 of designing the function and the performance of the microdevice, a step 202 of manufacturing a mask (reticle) based on the designing step, a step 203 of producing a substrate as a base material for the device, a substrate-processing step 204 including the exposure process of exposing the substrate with the patterns of the masks by the exposure apparatus EX of the embodiment described above and a developing process of developing the exposed substrate, a step 205 of assembling the device (including processing processes such as a dicing step, a bonding step, and a packaging step), and an inspection step 206.

### INDUSTRIAL APPLICABILITY

According to the present invention, the multiple exposure for the substrate can be realized correctly at a high efficiency. Therefore, it is possible to produce, at a high throughput, a device having a highly dense and complicated circuit pattern to be used, for example, for the liquid crystal display device and the micromachine. Therefore, the present invention will remarkably contribute to the development of the precision mechanical equipment industry including the semiconductor industry of our country.

## Claims

1. An exposure apparatus which exposes a substrate, comprising:
an optical system which is capable of forming an image of a first pattern in a first exposure area by radiating a first exposure light from the first pattern onto the first exposure area and which is capable of forming an image of a second pattern different from the first pattern in a second exposure area by radiating a second exposure light from the second pattern onto the second exposure area; and
a detecting system which has a light-receiving device receiving a detection light via at least a part of the optical system and which obtains information about a positional relationship between the image of the first pattern and the substrate and information about a positional relationship between the image of the second pattern and the substrate via at least the part of the optical system concurrently with at least a part of an operation for multiple-exposing a predetermined area on the substrate with the image of the first pattern formed in the first exposure area and the image of the second pattern formed in the second exposure area.

2. The exposure apparatus according to claim 1, wherein the detecting system obtains information about a positional relationship among the image of the first pattern, the image of the second pattern, and the substrate.

3. The exposure apparatus according to claim 1, wherein the predetermined area on the substrate is multiple-exposed while adjusting a positional relationship among the image of the first pattern, the image of the second pattern, and the predetermined area on the substrate based on the information obtained by the detecting system.

4. The exposure apparatus according to claim 1, wherein the predetermined area on the substrate is multiple-exposed, while moving the first pattern and the second pattern in scanning directions respectively and moving the substrate in a scanning direction.

5. The exposure apparatus according to claim 1, wherein the light-receiving device receives, as the detection light, a light from at least one of a first mark formed in a predetermined positional relationship with respect to the first pattern and a second mark formed in a predetermined positional relationship with respect to the second pattern, via at least the part of the optical system.

6. The exposure apparatus according to claim 1, wherein the light-receiving device receives the detection light having a wavelength same as that of at least one of the first exposure light and the second exposure light.

7. The exposure apparatus according to claim 6, wherein the light-receiving device receives, as the detection light, at least one of the first exposure light and the second exposure light.

8. The exposure apparatus according to claim 7, wherein the optical system includes an optical element into which the first exposure light from the first pattern and the second exposure light from the second pattern come and which is capable of irradiating at least a part of the first exposure light and at least a part of the second exposure light onto the first exposure area and the second exposure area respectively; and
the light-receiving device receives at least one of the first exposure light and the second exposure light traveling from the optical element to an area different from the first exposure area and the second exposure area.

9. The exposure apparatus according to claim 8, wherein the optical element includes a polarization splitting optical element.

10. The exposure apparatus according to claim 1, wherein the detecting system includes a radiating device which radiates another detection light different from the first and second exposure lights, and the light-receiving device receives the detection light from the radiating device via at least the part of the optical system.

11. The exposure apparatus according to claim 10, wherein the optical system includes an optical element having a first light-incident surface into which the first exposure light from the first pattern comes and a second light-incident surface into which the second exposure light from the second pattern comes, the optical element being capable of irradiating at least a part of the first exposure light and at least a part of the second exposure light onto the first exposure area and the second exposure area respectively; and
the radiating device radiates the detection light toward the optical element, and the light-receiving device receives at least one of the detection light from the first light-incident surface and the detection light from the second light-incident surface.

12. The exposure apparatus according to claim 11, wherein the optical element includes a polarization splitting optical element.

13. The exposure apparatus according to any one of claims 1 to 12, further comprising:
a first moving device which is capable of moving the first pattern in a predetermined scanning direction with respect to the first exposure light;
a second moving device which is capable of moving the second pattern in a predetermined scanning direction with respect to the second exposure light; and
a substrate-moving device which is capable of moving the predetermined area on the substrate in a predetermined scanning direction with respect to the first exposure area and the second exposure area,
wherein the predetermined area on the substrate is multiple-exposed while synchronously performing movement of the first pattern and the second pattern in the scanning directions by the first and second moving devices respectively and movement of the substrate in the scanning direction by the substrate-moving device.

14. An exposure apparatus which exposes a substrate, comprising:
an optical system including an optical element into which a first exposure light comes from a first pattern and into which a second exposure light comes from a second pattern different from the first pattern, the optical element being capable of forming an image of the first pattern and an image of the second pattern in a first exposure area and a second exposure area respectively by irradiating at least a part of the first exposure light from the optical element and at least a part of the second exposure light from the optical element onto the first exposure area and the second exposure area respectively; and
a detecting system including a light-receiving device which receives, as a detection light, a light traveling from the optical element to an area different from the first exposure area and the second exposure area,
wherein a predetermined area on the substrate is multiple-exposed with the image of the first pattern formed in the first exposure area and the image of the second pattern formed in the second exposure area.

15. The exposure apparatus according to claim 14, wherein a light-receiving surface of the light-receiving device is arranged at a position optically conjugate with the substrate or in the vicinity of the position.

16. The exposure apparatus according to claim 14, wherein the predetermined area on the substrate is multiple-exposed, while moving the first pattern and the second pattern in scanning directions respectively and moving the substrate in a scanning direction.

17. The exposure apparatus according to claim 14, wherein the light-receiving device receives the detection light having a wavelength same as that of at least one of the first exposure light and the second exposure light.

18. The exposure apparatus according to claim 14, wherein the light-receiving device receives, as the detection light, a light from at least one of a first mark formed in a predetermined positional relationship with respect to the first pattern and a second mark formed in a predetermined positional relationship with respect to the second pattern, via the optical element.

19. The exposure apparatus according to claim 18, wherein the detecting system obtains information about at least one of a positional relationship between the image of the first pattern and the image of the second pattern and a positional relationship between the first pattern and the second pattern based on a positional relationship between an image of the first mark and an image of the second mark formed on a light-receiving surface of the light-receiving device via the optical element.

20. The exposure apparatus according to claim 19, wherein the first mark is moved in a predetermined scanning direction together with the first pattern, and the second mark is moved in a predetermined scanning direction together with the second pattern; and
the detecting system obtains the information about at least one of the positional relationship between the image of the first pattern and the image of the second pattern and the positional relationship between the first pattern and the second pattern based on a timing at which the image of the first mark is formed at a first position on the light-receiving surface and a timing at which the image of the second mark is formed at a second position on the light-receiving surface.

21. The exposure apparatus according to claim 19, wherein the first mark is formed as a plurality of first marks formed in the scanning direction, and the second mark is formed as a plurality of second marks formed in the scanning direction.

22. The exposure apparatus according to claim 14, wherein the light-receiving device receives, as the detection light, a part, of at least one of the first exposure light and the second exposure light coming into the optical element, the part traveling to the area which is different from the first exposure area and the second exposure area.

23. The exposure apparatus according to claim 14, wherein the optical element has a first light-incident surface into which the first exposure light comes and a second light-incident surface into which the second exposure light comes; and
the detecting system radiates another detection light different from the first and second exposure lights to the optical element; and the light-receiving device receives at least one of the detection light from the first light-incident surface of the optical element and the detection light from the second light-incident surface of the optical element.

24. The exposure apparatus according to claim 23, wherein the detecting system radiates the detection light to the optical element, the detection light having a wavelength different from those of the first and second exposure lights.

25. The exposure apparatus according to claim 23, wherein the light-receiving device receives at least one of the detection light via the first light-incident surface and a first mark formed in a predetermined positional relationship with respect to the first pattern and the detection light via the second light-incident surface and a second mark formed in a predetermined positional relationship with respect to the second pattern.

26. The exposure apparatus according to claim 25, wherein the detecting system includes a first light-receiving device which receives the detection light from the first light-incident surface and a second light-receiving device which receives the detection light from the second light-incident surface; and
information about at least one of a positional relationship between the image of the first pattern and the image of the second pattern and a positional relationship between the first pattern and the second pattern is obtained based on the detection light radiated onto a first light-receiving surface of the first light-receiving device via the first mark and the detection light radiated onto a second light-receiving surface of the second light-receiving device via the second mark.

27. The exposure apparatus according to claim 26, wherein the first mark is moved in a predetermined scanning direction together with the first pattern, and the second mark is moved in a predetermined scanning direction together with the second pattern; and
the detecting system obtains the information about at least one of the positional relationship between the image of the first pattern and the image of the second pattern and the positional relationship between the first pattern and the second pattern based on a timing at which an image of the first mark is formed at a first position on the first light-receiving surface and a timing at which an image of the second mark is formed at a second position on the second light-receiving surface.

28. The exposure apparatus according to claim 27, wherein the first mark is formed as a plurality of first marks formed in the scanning direction, and the second mark is formed as a plurality of second marks formed in the scanning direction.

29. The exposure apparatus according to any one of claims 14 to 28, wherein position information about at least one of the first pattern and the second pattern is obtained based on an output of the light-receiving device.

30. The exposure apparatus according to any one of claims 14 to 28, wherein information about a positional relationship between the first pattern and the second pattern is obtained based on an output of the light-receiving device.

31. The exposure apparatus according to any one of claims 14 to 28, wherein at least one of position information about the image of the first pattern formed in the first exposure area and position information about the image of the second pattern formed in the second exposure area is obtained based on an output of the light-receiving device.

32. The exposure apparatus according to any one of claims 14 to 28, wherein a position of at least one of the first pattern and the second pattern is adjusted based on an output of the light-receiving device.

33. The exposure apparatus according to any one of claims 14 to 28, wherein a positional relationship between the image of the first pattern formed in the first exposure area and the image of the second pattern formed in the second exposure area is adjusted based on an output of the light-receiving device.

34. The exposure apparatus according to any one of claims 14 to 28, wherein a detecting operation of the detecting system is executed before the multiple exposure is started for the predetermined area on the substrate.

35. The exposure apparatus according to any one of claims 14 to 28, wherein a detecting operation of the detecting system is executed concurrently with at least a part of an operation for multiple-exposing the predetermined area on the substrate.

36. The exposure apparatus according to any one of claims 14 to 28, wherein the optical element includes a branching optical element which branches an optical path of each of the first exposure light and the second exposure light.

37. The exposure apparatus according to any one of claims 14 to 28, wherein the optical element includes a polarization splitting optical element which splits each of the first exposure light and the second exposure light into an exposure light with a first polarization and an exposure light with a second polarization.

38. The exposure apparatus according to any one of claims 14 to 28, wherein the optical system includes:
a first optical system which guides the first exposure light from the first pattern to the optical element;
a second optical system which guides the second exposure light from the second pattern to the optical element; and
a third optical system which guides each of the first exposure light and the second exposure light from the optical element to the first exposure area and the second exposure area respectively.

39. The exposure apparatus according to any one of claims 14 to 28, further comprising:
a first moving device which is capable of moving the first pattern in a predetermined scanning direction with respect to the first exposure light;
a second moving device which is capable of moving the second pattern in a predetermined scanning direction with respect to the second exposure light; and
a substrate-moving device which is capable of moving the predetermined area on the substrate in a predetermined scanning direction with respect to the first exposure area and the second exposure area,
wherein the predetermined area on the substrate is multiple-exposed while synchronously performing movement of the first pattern and the second pattern in the scanning directions respectively by the first and second moving devices and movement of the substrate-moving device in the scanning direction.

40. An exposure apparatus which exposes a substrate, comprising:
a polarization splitting optical element into which a first exposure light comes from a first pattern and into which a second exposure light comes from a second pattern different from the first pattern; and
a detecting system which detects a position of a first mark associated with the first pattern and a position of a second mark associated with the second pattern by detecting the first mark and the second mark via the polarization splitting optical element,
wherein the first exposure light and the second exposure light from the polarization splitting optical element are irradiated onto a first exposure area and a second exposure area respectively to form an image of the first pattern and an image of the second pattern in the first exposure area and the second exposure area respectively so that a predetermined area on the substrate is multiple-exposed.

41. The exposure apparatus according to claim 40, wherein the first exposure light and the second exposure light come into the polarization splitting optical element in different directions, and a part of the first exposure light and a part of the second exposure light, which exit from the polarization splitting optical element, travel in a same direction.

42. The exposure apparatus according to claim 40, further comprising a controller which adjusts a position of at least one of the image of the first pattern and the image of the second pattern based on a result of detection performed by the detecting system.

43. The exposure apparatus according to claim 41, further comprising a detector which detects the image of the first pattern and the image of the second pattern, wherein the controller correlates a result of detection performed by the detector with a result of detection performed by the detecting system.

44. The exposure apparatus according to claim 40, further comprising a projection optical system which projects the image of the first pattern and the image of the second pattern onto the first exposure area and the second exposure area and which includes the polarization splitting optical element.

45. The exposure apparatus according to claim 40, wherein a liquid immersion area is formed on the substrate, and the multiple exposure is performed through a liquid of the liquid immersion area.

46. A method for producing a device, comprising:
exposing a substrate by using the exposure apparatus as defined in any one of claims 1 to 45;
developing the exposed substrate; and
processing the developed substrate.

47. An exposure method for exposing a substrate, comprising:
multiple-exposing a predetermined area on the substrate with an image of a first pattern and an image of a second pattern different from the first pattern by radiating a first exposure light from the first pattern onto a first exposure area via an optical system to form the image of the first pattern in the first exposure area while radiating a second exposure light from the second pattern onto a second exposure area via the optical system to form the image of the second pattern in the second exposure area; and
obtaining information about a positional relationship between the image of the first pattern and the substrate and information about a positional relationship between the image of the second pattern and the substrate via at least a part of the optical system concurrently with at least a part of an operation of the multiple exposure.

48. The exposure method according to claim 47, wherein the predetermined area on the substrate is multiple-exposed while adjusting a positional relationship among the image of the first pattern, the image of the second pattern, and the predetermined area on the substrate based on the obtained information.

49. The exposure method according to claim 47, wherein the predetermined area on the substrate is multiple-exposed while moving the first pattern and the second pattern in predetermined directions respectively and moving the substrate in a direction corresponding to the predetermined directions.

50. The exposure method according to claim 47, wherein a light, from at least one of a first mark formed in a predetermined positional relationship with respect to the first pattern and a second mark formed in a predetermined positional relationship with respect to the second pattern, is received as a detection light via at least the part of the optical system.

51. The exposure method according to claim 47, wherein the first exposure light from the first pattern and the second exposure light from the second pattern are radiated so that the first exposure area and the second exposure area are overlaid.

52. An exposure method for exposing a substrate, comprising:
multiple-exposing a predetermined area on the substrate with an image of a first pattern and an image of a second pattern different from the first pattern by radiating a first exposure light from the first pattern onto a first exposure area via an optical element to form the image of the first pattern in the first exposure area while radiating a second exposure light from the second pattern onto a second exposure area via the optical element to form the image of the second pattern in the second exposure area; and
receiving, as a detection light, a light traveling from the optical element to an area different from the first exposure area and the second exposure area.

53. The exposure method according to claim 52, wherein the predetermined area on the substrate is multiple-exposed while moving the first pattern and the second pattern in predetermined directions respectively and moving the substrate in a direction corresponding to the predetermined directions.

54. The exposure method according to claim 52, wherein the detection light is a light from at least one of a first mark which is formed in a predetermined positional relationship with respect to the first pattern and a second mark which is formed in a predetermined positional relationship with respect to the second pattern.

55. The exposure method according to claim 54, wherein information, about at least one of a positional relationship between the image of the first pattern and the image of the second pattern and a positional relationship between the first pattern and the second pattern, is obtained based on a positional relationship between the image of the first mark and the image of the second mark.

56. The exposure method according to claim 55, wherein the first mark is moved in a predetermined scanning direction together with the first pattern and the second mark is moved in a predetermined scanning direction together with the second pattern; and the information, about at least one of the positional relationship between the image of the first pattern and the image of the second pattern and the positional relationship between the first pattern and the second pattern, is obtained based on a timing at which the image of the first mark is formed at a first position and a timing at which the image of the second mark is formed at a second position.

57. An exposure method for exposing a substrate, comprising:
making a first exposure light from a first pattern and a second exposure light from a second pattern different from the first pattern to come into a polarization splitting optical element;
detecting a position of a first mark associated with the first pattern and a position of a second mark associated with the second pattern by detecting the first mark and the second mark with a detection light via the polarization splitting optical element; and
irradiating the first exposure light and the second exposure light from the polarization splitting optical element onto a first exposure area and a second exposure area respectively to form an image of the first pattern and an image of the second pattern in the first exposure area and the second exposure area respectively so that a predetermined area on the substrate is multiple-exposed.

58. The exposure method according to claim 57, wherein the predetermined area on the substrate is multiple-exposed with the image of the first pattern and the image of the second pattern while detecting the positions of the first and second marks.

59. The exposure method according to claim 57, further comprising adjusting a position of at least one of the image of the first pattern and the image of the second pattern based on the detected positions of the first and second marks.

60. The exposure method according to claim 57, further comprising detecting images of the first and second marks before the multiple exposure at a first position at which the first exposure area and the second exposure area are to be formed, while detecting the images of the first and second marks at a second position to which the detection light travels via the polarization splitting optical element; and correlating position information detected at the first position with position information detected at the second position.

61. The exposure method according to claim 60, wherein each of the first exposure light and the second exposure light is split into light beams which travel to the first position and the second position, by the polarization splitting optical element.

62. The exposure method according to claim 57, wherein a liquid immersion area is formed on the substrate, and the multiple exposure is performed through a liquid of the liquid immersion area.

63. A method for producing a device, comprising:
exposing a substrate by the method as defined in any one of claims 47 to 62;
developing the exposed substrate; and
processing the developed substrate.
